# EUROPEAN PATENT APPLICATION

(11) **EP 4 668 499 A1**
(43) Date of publication of application: **24.12.2025**
(21) Application number: 23948951.1
(22) Date of filing: 13.09.2023
(51) Int. Cl.: H01R 13/02

(54) **POWER DISTRIBUTION APPARATUS, BATTERY, AND ELECTRICAL DEVICE**

(30) Priority: 17.08.2023 CN 202311041205
(71) Applicant: Contemporary Amperex Technology Co., Limited, Ningde, Fujian 352100 (CN)
(72) Inventor: LI, Yuanxin, Ningde, Fujian 352100 (CN); WANG, Chong, Ningde, Fujian 352100 (CN); ZHENG, Chenling, Ningde, Fujian 352100 (CN)
(74) Representative: Gong, Jinping
(86) International application number: PCT/CN2023/118580
(87) International publication number: WO 2025/035526

(57) **Abstract**

A power distribution apparatus (100), a battery (1100), and a power consuming device are provided. The power distribution apparatus (100) includes a first electrical member (110) and a second electrical member (120). The first electrical member (110) includes a first connection terminal (111), and the first connection terminal (111) is configured to electrically connect the first electrical member (110) to another electrical member; and a first gap (1001) is formed between the second electrical member (120) and the first electrical member (110), where the first connection terminal (111) is located outside the first gap (1001), so that a connection operation space required by the first connection terminal (111) is moved out of the first gap (1001), thereby reducing the spacing between the first electrical member (110) and the second electrical member (120), and improving the structural compactness of the entire power distribution apparatus (100), which is beneficial to reducing the outline size of the entire power distribution apparatus (100), and is also beneficial to improving performance of a power consuming device and reducing costs of the power consuming device.

## Description

The present application claims priority to Chinese Patent Application No. 202311041205.X, entitled "POWER DISTRIBUTION APPARATUS, BATTERY, AND POWER CONSUMING DEVICE" filed with the China National Intellectual

### TECHNICAL FIELD

The present application relates to the field of electrical distribution technologies, and in particular, to a power distribution apparatus, a battery, and a power consuming device.

### BACKGROUND

With the development of science and technology, applications of power consuming devices are increasingly widespread, for example a mobile phone, a tablet computer, a notebook computer, an electric toy, a power tool, an electric bike, an electric vehicle, a ship, or a spacecraft. The power consuming device is usually provided with a power distribution apparatus, to assist in running of the power consuming device. The power distribution apparatus includes a plurality of electrical members, and a large spacing between two electrical members causes poor structural compactness and a large overall outline size of the power distribution apparatus, and affects performance and manufacturing costs of the power consuming device.

The statement herein merely provides background information related to the present application and does not necessarily constitute the prior art.

### SUMMARY

An objective of embodiments of the present application is to: provide a power distribution apparatus, a battery, and a power consuming device, and includes but is not limited to resolving a problem in the related technology that a large spacing between electrical members in a battery assembly causes poor structural compactness and a large overall outline size of the power distribution apparatus.

The technical solutions used in the embodiments of the present application are as follows:
According to a first aspect, a power distribution apparatus is provided. The power distribution apparatus includes a first electrical member and a second electrical member, where the first electrical member includes a first connection terminal, and the first connection terminal is configured to electrically connect the first electrical member to another electrical member; and a first gap being formed between the second electrical member and the first electrical member, where the first connection terminal is located outside the first gap.

In the power distribution apparatus of this embodiment of the present application, the first gap is formed between the first electrical member and the second electrical member, and the first connection terminal of the first electrical member is located outside the first gap, so that a connection operation space required by the first connection terminal may be moved out of the first gap, thereby reducing the spacing between the first electrical member and the second electrical member, and improving the structural compactness of the entire power distribution apparatus, which is beneficial to reducing the outline size of the entire power distribution apparatus, and is also beneficial to improving performance of a power consuming device and reducing costs of the power consuming device.

In an embodiment, the second electrical member includes a second connection terminal configured to electrically connect the second electrical member to another electrical member, and the second connection terminal is located outside the first gap.

By using the technical solution of this embodiment, a connection operation space required by the second connection terminal may not occupy the first gap. In this way, a spacing between the second electrical member and the first electrical member may be set to be small, so that the power distribution apparatus has better structural compactness and a smaller overall size, which is more beneficial to improving performance of a power consuming device and reducing costs of the power consuming device.

In an embodiment, at least two second electrical members are disposed, the first gap is formed between each of the second electrical members and the first electrical member, and the first connection terminal is located outside each first gap; and/or at least one second connection terminal is located outside each first gap.

By using the technical solution of this embodiment, a spacing between the second electrical member and the first electrical member may be reduced, so that the power distribution apparatus has better structural compactness and a smaller overall size, which is more beneficial to improving performance of a power consuming device and reducing costs of the power consuming device.

In an embodiment, a second gap is formed between two adjacent second electrical members, and the first connection terminal is located outside each second gap; and/or the at least one second connection terminal is located outside each second gap.

By using the technical solution of this embodiment, connection operation spaces required by the first connection terminals located outside all second gaps are staggered from the second gaps, and connection operation spaces required by the second connection terminals located outside all second gaps are staggered from the second gaps. At least one of the two manners can enable a spacing between two adjacent second electrical members to be set to be small, so that the power distribution apparatus has better structural compactness and a smaller overall size, which is more beneficial to improving performance of a power consuming device and reducing costs of the power consuming device.

In an embodiment, the first connection terminal and the at least one second connection terminal are located on a same side of the first electrical member and the second electrical member.

By using the technical solution of this embodiment, connection operation spaces required by the first connection terminal and the at least one second connection terminal are centralized on a same side of the first electrical member and the second electrical member, which is beneficial to reducing an overall size of the power distribution apparatus, and beneficial to improving performance of the power consuming device and reducing costs of the power consuming device. In addition, an electrical connection operation may be performed on the first connection terminal and the second connection terminal on a same side of the first electrical member and the second electrical member, which also facilitates assembly of the power distribution apparatus.

In an embodiment, the power distribution apparatus further includes a third electrical member, the third electrical member and the first electrical member are located on different sides of the second electrical member, a third gap is formed between the second electrical member and the third electrical member, and the at least one second connection terminal is located outside the third gap.

By using the technical solution of this embodiment, a connection operation space required by the at least one second connection terminal may not occupy the third gap. In this way, a spacing between the second electrical member and the third electrical member may be set to be small, so that the power distribution apparatus has better structural compactness and a smaller overall size, which is more beneficial to improving performance of a power consuming device and reducing costs of the power consuming device.

In an embodiment, the third electrical member includes a third connection terminal configured to electrically connect the third electrical member to another electrical member, and the third connection terminal is located outside the third gap.

By using the technical solution of this embodiment, a connection operation space required by the third connection terminal may not occupy the third gap. In this way, a spacing between the third electrical member and the second electrical member may be set to be small, so that the power distribution apparatus has better structural compactness and a smaller overall size, which is more beneficial to improving performance of a power consuming device and reducing costs of the power consuming device.

In an embodiment, the third connection terminal and the at least one second connection terminal are located on a same side of the second electrical member and the third electrical member.

By using the technical solution of this embodiment, connection operation spaces required by the third connection terminal and the at least one second connection terminal are centralized on a same side of the second electrical member and the third electrical member, which is beneficial to reducing an overall size of the power distribution apparatus, and beneficial to improving performance of the power consuming device and reducing costs of the power consuming device. An electrical connection operation is performed on the second connection terminal and the third connection terminal on a same side of the second electrical member and the third electrical member, which also facilitates assembly of the power distribution apparatus.

In an embodiment, the first electrical member, at least one second electrical member, and at least one third electrical member are in a linear arrangement.

By using the technical solution of this embodiment, the first electrical member, the second electrical member, and the third electrical member are simply arranged, which may facilitate disposition of the first connection terminal, the second connection terminal, and the third connection terminal, facilitate assembly and manufacturing of the power distribution apparatus, and is also beneficial to reducing an overall size of the power distribution apparatus in a direction perpendicular to a linear arrangement direction, thereby achieving better overall structural compactness.

In an embodiment, the first electrical member has a first lateral portion opposite to the second electrical member, and the first connection terminal is located on a lateral portion of the first electrical member adjacent to the first lateral portion.

By using the technical solution of this embodiment, the first connection terminal is located on a lateral portion of the first electrical member adjacent to the first lateral portion. In this way, a connection operation space required by the first connection terminal is located on a side of an arrangement direction of the first electrical member and the second electrical member, and the connection operation space does not overlap in the arrangement direction of the first electrical member and the second electrical member, so that a size of the power distribution apparatus in the arrangement direction of the first electrical member and the second electrical member can be reduced, which helps improve structural compactness.

In an embodiment, a plurality of first connection terminals are disposed, and at least two of the first connection terminals are located on a same side of the first electrical member.

By using the technical solution of this embodiment, connection operation spaces required by the at least two first connection terminals are centralized on a same side of the first electrical member, so that the at least two first connection terminals are staggered from the first gaps, which is beneficial to reducing a spacing between the first electrical member and the second electrical member, thereby reducing an overall size of the power distribution apparatus, and achieving better overall structural compactness. In addition, a connection operation may be performed on the at least two first connection terminals on a same side of the first electrical member, to facilitate an electrical connection operation on the power distribution apparatus.

In an embodiment, the power distribution apparatus further includes a first electrical connection member, the first electrical connection member has a first end and a second end, the first end is configured to connect to another electrical member different from the first electrical member, and the second end is configured to electrically plug into the first connection terminal.

By using the technical solution of this embodiment, the first electrical connection member may implement communication between the first electrical member and another electrical member, and the first electrical connection member and the first connection terminal are electrically connected in a manner of electrical plugging. The connection manner is simple, and assembly of the power distribution apparatus is convenient.

In an embodiment, the first connection terminal includes a body and an elastic member, the body is constructed with a plugging hole, the elastic member is located in the plugging hole, the second end is inserted into the plugging hole, and the second end elastically butts against the elastic member, to elastically clamp the second end in the plugging hole.

By using the technical solution of this embodiment, the second end is elastically snapped in the plugging hole, the plugging stability between the first electrical connection member and the first connection terminal is good, and the electrical connection is more stable and reliable. In addition, the structure of the first connection terminal is simple, the second end is elastically snapped in the plugging hole by using the elastic member, and the first electrical connection member can be plugged into the first connection terminal for a plurality of times, to facilitate assembly and maintenance.

In an embodiment, the second end has a sheet shape.

By using the technical solution of this embodiment, the second end has a sheet shape. In this way, after the second end is inserted into the plugging hole, the second end and the elastic member may have a large butting area, so that the plugging stability between the first electrical connection member and the first connection terminal is better, and the electrical connection is more stable and reliable.

In an embodiment, the power distribution apparatus further includes a first shell cover and a mounting base, the first shell cover is mounted on the mounting base, the first shell cover and the mounting base define a mounting space, the first electrical member and the second electrical member are located in the mounting space, the first electrical connection member is mounted on the first shell cover, and a plugging opening of the first connection terminal is disposed toward the first shell cover.

By using the technical solution of this embodiment, because the first connection terminal faces the first shell cover, during assembly of the power distribution apparatus, assembly of the components and electrical plugging of the first connection terminal may be simultaneously completed, to help improve assembly efficiency of the power distribution apparatus. In addition, the second end and the first connection terminal may be automatically docked. Compared with manual plugging, plugging requires a small space, which is beneficial to reducing a spacing between the first electrical member and the second electrical member and improving structural compactness of the power distribution apparatus.

In an embodiment, the first electrical connection member is embedded in the first shell cover.

By using the technical solution of this embodiment, the first shell cover may play a role in of protecting the first electrical connection member, thereby improving use reliability of the power distribution apparatus. In addition, the first electrical connection member is located in the first shell cover, to help improve the structural compactness of the power distribution apparatus, and also help reduce the overall size of the power distribution apparatus.

In an embodiment, the first electrical member is a relay; the relay includes a switching unit, and the first connection terminal is electrically connected to the switching unit; and the mounting base is constructed with a first accommodating cavity, and the switching unit is exposed in the first accommodating cavity.

By using the technical solution of this embodiment, the switching unit of the relay is directly exposed in the first accommodating cavity. In this way, in the power distribution apparatus, a space occupied by the shell of the relay may be saved, thereby improving structural compactness of the power distribution apparatus, and helping improve performance of the power distribution apparatus and reduce manufacturing costs. In addition, the relay is generally a component with a large volume in the power distribution apparatus, and the shell of the relay is omitted, so that a large space can be saved for the power distribution apparatus, thereby effectively improving the structural compactness of the power distribution apparatus.

In an embodiment, the first electrical member is a resistor, a fuse, or a current sensor; and/or the second electrical member is a relay, a resistor, a fuse, or a current sensor.

By using the technical solution of this embodiment, the structure of the power distribution apparatus may be set flexibly, and processing and manufacturing are convenient.

According to a second aspect, a battery is provided, including the power distribution apparatus according to the foregoing embodiments.

According to a third aspect, a power consuming device is provided, including the power distribution apparatus according to the foregoing embodiments; and/or including the battery according to the foregoing embodiments.

The above descriptions only refer to an overview of the technical solution of the present application. To understand the technical means of the present application more clearly, it can be implemented according to the content of the descriptions. To make the foregoing and other objectives, features and advantages of the present application more apparent, the specific implementations of the present application are listed below.

### BRIEF DESCRIPTION OF THE DRAWINGS

To describe the technical solutions in the embodiments of the present application more clearly, the following briefly introduces the accompanying drawings required for describing the embodiments or the related art. Apparently, the accompanying drawings in the following descriptions show merely some embodiments of the present application, and a person of ordinary skill in the art may still derive other accompanying drawings from these accompanying drawings without creative efforts.
FIG. 1 is a schematic diagram of a structure of a vehicle according to an embodiment of the present application;
FIG. 2 is a schematic diagram of a structure of a battery according to another embodiment of the present application;
FIG. 3 is a schematic diagram of a structure of a battery cell according to still another embodiment of the present application;
FIG. 4 is a schematic exploded view of the battery cell shown in FIG. 3;
FIG. 5 is a schematic diagram of a structure of a power distribution apparatus according to still another embodiment of the present application;
FIG. 6 is a schematic exploded view of the power distribution apparatus shown in FIG. 5 from an angle of view;
FIG. 7 is a schematic diagram of arrangement of a first electrical member, a second electrical member, and a third electrical member in FIG. 6;
FIG. 8 is a schematic exploded view of the power distribution apparatus shown in FIG. 5 from another angle of view;
FIG. 9 is a cross-sectional view along a line A-A in FIG. 5;
FIG. 10 is a partial enlarged view at B in FIG. 9;
FIG. 11 is a schematic diagram of a structure of a first electrical member shown in in FIG. 7;
FIG. 12 is a schematic exploded view of a power distribution apparatus according to still another embodiment of the present application; and
FIG. 13 is a schematic diagram of arrangement of a first electrical member, a second electrical member, a third electrical member, and a fourth electrical member in FIG. 12.

Reference numerals in the drawings are as follows:
1000 vehicle; 1100 battery; 1200 controller; 1300 motor; 10 box; 11 first part; 12 second part; 20 battery cell; 21 end cover; 211 electrode terminal; 212 pressure relief mechanism; 22 shell; 23 electrode assembly; 100 power distribution apparatus; 1001 first gap; 1002 second gap; 1003 third gap; 1004 fourth gap; 101 pre-charge relay; 102 main positive relay; 103 pre-charge resistor; 104 fuse; 105 main negative relay; 110 first electrical member; 110a relay; 111 first connection terminal; 1111 body; 1112 elastic member; 11111 plugging hole; 112 first electrically conductive member; 113 first lateral portion; 114 switching unit; 120 second electrical member; 121 second connection terminal; 122 second electrically conductive member; 130 third electrical member; 131 third connection terminal; 132 third electrically conductive member; 140 housing; 141 first shell cover; 1411 surrounding edge; 14111 snap-fit fastener; 1412 insulating and isolating plate; 1413 fifth accommodating cavity; 1414 sixth accommodating cavity; 142 mounting base; 1421 first accommodating cavity; 1422 second accommodating cavity; 1423 third accommodating cavity; 1424 fourth accommodating cavity; 1425 second insulating and isolating member; 1426 seventh accommodating cavity; 143 second shell cover; 1431 accommodating hole; 151 first electrical connection member; 152 second electrical connection member; 160 insulating and thermally conductive member; 171 first insulating covering member; 1711 first insulating portion; 172 second insulating covering member; 1721 second insulating portion; 180 fourth electrical member; and 181 fourth connection terminal.

### DETAILED DESCRIPTION

To make the technical problems solved by the present application, the technical solutions, and the beneficial effects clearer, the present application is further described below in detail with reference to the accompanying drawings and the embodiments. Specific embodiments described herein are merely used to explain the present application but are not intended to limit the present application.

Unless otherwise defined, all technical and scientific terms used in this specification have same meanings as those commonly understood by a person skilled in the art to which the present application belongs. The terms used in this specification are only intended to describe specific embodiments, and are not intended to limit the present application. The terms "include", "include", and any variants thereof in the specification and claims of the present application and the foregoing accompanying drawings are intended to cover non-exclusive inclusion.

In the descriptions of the embodiments of the present application, the technical terms "first", "second", and the like are only used to distinguish different objects, and should not be understood as indicating or implying relative importance or implying the number, specific order or primary and secondary relationship of indicated technical features. Therefore, features defining "first" and "second" may explicitly or implicitly include one or more such features.

Reference in this specification to "an embodiment" means that a specified feature, structure, or characteristic described with reference to the embodiment may be included in at least one embodiment of the present application. Appearances of the phrase in various locations in this specification are not necessarily all referring to a same embodiment, nor are separate or alternative embodiments mutually exclusive of another embodiment. It is explicitly and implicitly understood by a person skilled in the art that embodiments described in this specification may be combined with another embodiment in any proper manner.

In the description of the examples of the present application, the term "and/or" merely describes an association relationship of associated objects and represents that three relationships may exist, for example, A and/or B may represent the following three cases: A exists alone, A and B exist at the same time, and B exists alone. In addition, the character "/" in this specification generally indicates an "or" relationship between the associated objects.

In the descriptions of the embodiments of the present application, the term "a plurality of" means two or more (including two). Similarly, "a plurality of groups" means two or more groups (including two groups), and "a plurality of members" means two or more members (including two members). "some" means one or more, unless otherwise expressly and specifically defined.

In the descriptions of the embodiments of the present application, the directions or positional relationships indicated by the technical terms such as "center", "longitudinal", "transverse", "length", "width", "thickness", "upper", "lower", "front", "rear", "left", "right", "vertical", "horizontal", "top", "bottom", "inside", "outside", "clockwise", "counterclockwise", "axial", "radial", and "circumferential", are only for the convenience of describing the present application and simplifying the descriptions, rather than indicating or implying that the involved device or element should have a specific orientation or should be configured or operated in the specific orientation, therefore, they cannot be understood as limiting the present application.

In the descriptions of the embodiments of the present application, unless otherwise expressly specified and defined, the technical terms "mounted", "connected to", "connected with", "fixed", or the like should be interpreted in a broad sense. For example, a connection may refer to a fixed connection, a disassembly connection or an integral connection; or may refer to a mechanical connection or an electrical connector; or may refer to a direct connection or an indirect connection through an intermediate medium; or may refer to an internal communication between the two elements or the interaction relationship between the two elements. For those skilled in the art, the specific meanings of the above terms in the embodiments of the present application may be interpreted according to the specific situations.

In the descriptions of the embodiments of the present application, unless otherwise expressly specified and defined, when an element is described as being "fixed on" or "disposed on" another element, the element may be directly located on the another element, or indirectly located on the another element. When an element is described as being "connected to" another element, the element may be directly connected to the another element, or indirectly connected to the another element.

In the descriptions of the embodiments of the present application, unless otherwise expressly specified and defined, the technical term "adjacent" refers to being close in position. For example, for three components, A1, A2, and B, a distance between A1 and B is greater than a distance between A2 and B. In this case, if A2 is compared with A1, A2 is closer to B, that is, A2 is adjacent to B, or B is adjacent to A2. For another example, when there are a plurality of components C, the plurality of components C are respectively C1, C2, ..., and CN. When one of the components C, for example, C2, is closer to B than other components C, B is adjacent to C2, or C2 is adjacent to B.

With the development of science and technology, applications of power consuming devices are increasingly widespread. The power consuming device may be, but is not merely limited to, a mobile phone, a tablet computer, a notebook computer, an electric toy, a power tool, an electric bike, an electric vehicle, a ship, a spacecraft, or the like. The power consuming device is usually provided with a power distribution apparatus, to assist in running of the power consuming device. A power consuming device may refer to an apparatus using a battery as a power supply. The power supply provides power for the power consuming device, so as to drive the power consuming device to work. The power consuming device is usually provided with a power distribution apparatus, and the power distribution apparatus is configured to control running of a high-voltage circuit in the power consuming device. The "voltage" in the high-voltage circuit refers to an electric pressure, and the high-voltage circuit refers to a circuit whose electric pressure exceeds 60 V. The power distribution apparatus includes a plurality of electrical members. The electrical members are electrically connected to each other by using an electrical connection member. An electrical member usually has a connection terminal. One end of the electrical connection member is connected to the connection terminal, and the other end is electrically connected to another electrical member, thereby implementing electrically conductive between the electrical members.

However, the connection terminal is usually located between the two electrical members, and a spacing between the two electrical members is usually set to be large, so as to provide a connection operation space for an electrical connection member and the connection terminal, thereby facilitating an electrical connection between the electrical connection member and the connection terminal. However, a large spacing between the electrical members leads to low space utilization of the entire power distribution apparatus, poor structural compactness, and a large overall outline size, which are not beneficial to improving performance of the power consuming device and reducing manufacturing costs of the power consuming device.

To improve the structural compactness of the power distribution apparatus, an embodiment of the present application provides a power distribution apparatus. The power distribution apparatus includes a first electrical member and a second electrical member. A first gap is formed between the first electrical member and the second electrical member, and the first connection terminal of the first electrical member is located outside the first gap, so that a connection operation space required by the first connection terminal may be moved out of the first gap, thereby reducing the spacing between the first electrical member and the second electrical member, and improving the structural compactness of the entire power distribution apparatus, which is beneficial to reducing the outline size of the entire power distribution apparatus, and is beneficial to improving performance of a power consuming device and reducing costs of the power consuming device.

The embodiments of the present application disclose a power distribution apparatus, a battery, and a power consuming device. From the perspective of development of the market situation, battery applications have proliferated. The batteries are used in energy storage power systems such as water power plants, fire power plants, wind power plants, and solar power plants, and are also widely used in electric mobility devices such as electric bicycles, electric motorcycles, electric vehicles, as well as in military equipment, aerospace, and other fields. With continuous expansion of the application fields of the power batteries, market demands for the power batteries are also expanding. The power consuming device may be, but is not limited to, a mobile phone, a tablet computer, a notebook computer, an electric toy, a power tool, an electric bike, an electric vehicle, a ship, a spacecraft, or the like. The electric toy may include a fixed or mobile electric toy, for example, a game console, an electric automobile toy, an electric ship toy, and an electric airplane toy. The spacecraft may include an airplane, a rocket, a spacecraft, a spaceship, and the like.

For ease of description, the power consuming device being a vehicle 1000 in an embodiment of the present application is used as an example to describe the following embodiments.

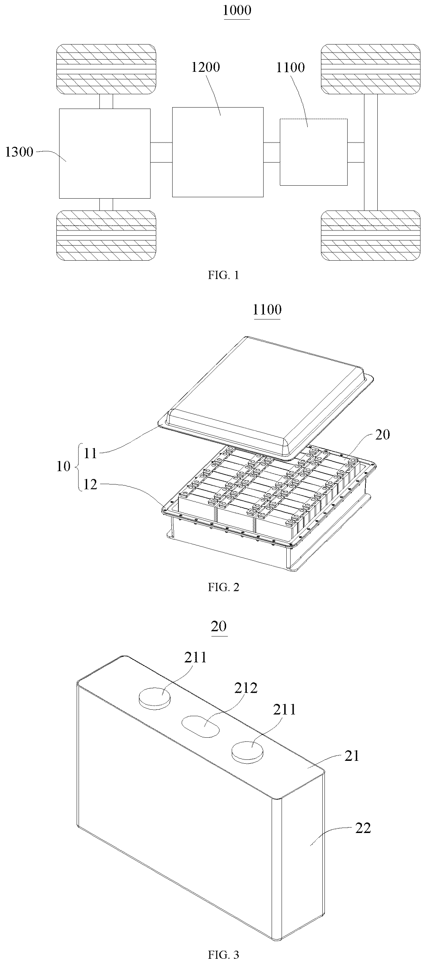

Referring to FIG. 1, the vehicle 1000 may be a fuel powered vehicle, a gas powered vehicle, or a new energy vehicle. The new energy vehicle may be a pure electric vehicle, a hybrid electric vehicle, an extended range vehicle, or the like. A battery 1100 is arranged inside the vehicle 1000. The battery 1100 may be arranged on the bottom, head, or tail of the vehicle 1000. The battery 1100 may be configured to supply power to the vehicle 1000. For example, the battery 1100 may be used as a power supply for operating the vehicle 1000. The vehicle 1000 may further include a controller 1200 and a motor 1300. The controller 1200 is configured to control the battery 1100 to supply power to the motor 1300, for example, to be used for working electricity requirements during startup, navigation, and driving of the vehicle 1000.

In some embodiments of the present application, the battery 1100 can not only serve as a power supply for operating the vehicle 1000, but can also serve as a power supply for driving the vehicle 1000, in place of or partially in place of fuel or natural gas, to provide driving power for the vehicle 1000.

Referring to FIG. 2, as an embodiment of the battery 1100, the battery 1100 includes a box 10 and battery cells 20, where the battery cells 20 are accommodated in the box 10. The box 10 is configured to provide an accommodating space for the battery cells 20. The box 10 may be of a variety of structures. In some embodiments, the box 10 may include a first part 11 and a second part 12, the first part 11 and the second part 12 cover each other, and the first part 11 and the second part 12 jointly define the accommodating space for accommodating the battery cells 20. The second part 12 may be a hollow structure being open on one side, the first part 11 may be a plate-like structure, and the first part 11 covers an open side of the second part 12, so that the first part 11 and the second part 12 jointly define the accommodating space. Alternatively, each of the first part 11 and the second part 12 may be a hollow structure being open on one side, and an open side of the first part 11 covers an open side of the second part 12. Certainly, the box 10 formed by the first part 11 and the second part 12 may be in various shapes, such as a cylinder, and a cuboid.

In the battery 1100, there may be a plurality of battery cells 20, and the plurality of battery cells 20 may be connected in series, parallel, or series-parallel. Series-parallel connection means that both series connection and parallel connection exist among the plurality of battery cells 20.

In an embodiment, the plurality of battery cells 20 may be directly connected in series, parallel, or series-parallel together, and then a whole formed by the plurality of battery cells 20 may be accommodated in the box 10. Certainly, the battery 1100 may also be in the form of a battery module formed by the plurality of battery cells 20 that are first connected in series, parallel, or series-parallel. A plurality of battery modules are then connected in series, parallel, or series-parallel to form a whole and accommodated in the box 10. The battery 1100 may alternatively be of another structure. For example, the battery 1100 may further include a busbar component, configured to implement electrical connection between the plurality of battery cells 20.

Each battery cell 20 may be a secondary battery or a primary battery; or may be a lithium-sulfur battery, a sodium-ion battery, or a magnesium-ion battery, but is not limited thereto. The battery cell 20 may be cylindrical, flat-shaped, cuboid-shaped, or in another shape.

As another embodiment of the battery 1100, the battery 1100 may not include the box 10. Instead, the plurality of battery cells 20 is electrically connected, and is integrated by using a necessary fixing structure and then assembled into a power consuming device.

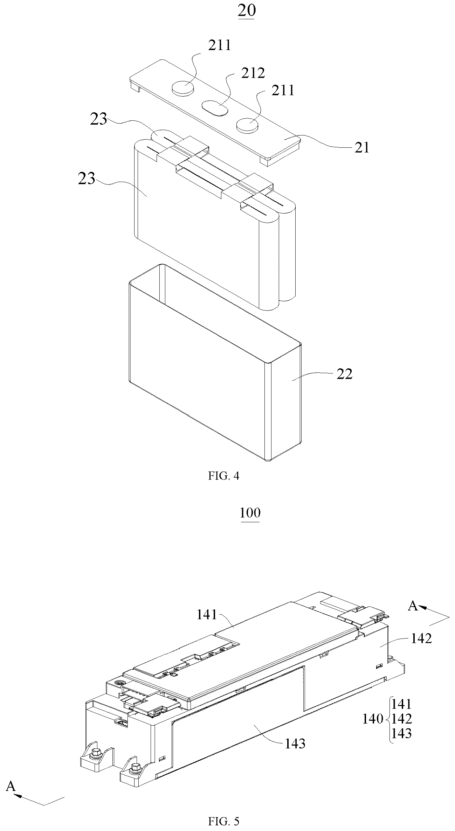

Referring to FIG. 3 and FIG. 4, the battery cell 20 is a smallest unit forming a battery. As shown in FIG. 3, the battery cell 20 includes an end cover 21, a shell 22, an electrode assembly 23, and other functional components.

The end cover 21 refers to a component that covers an opening of the shell 22 to isolate an internal environment of the battery cell 20 from an external environment. A shape of the end cover 21 is not limited and may be adapted to a shape of the shell 22 to fit the shell 22. Optionally, the end cover 21 may be made of a material with specified hardness and strength (for example, aluminum alloy), so that the end cover 21 is less likely to deform under extrusion and collision, enabling the battery cell 20 to have a higher structural strength and enhanced safety performance. A functional component such as the electrode terminal 211 may be disposed on the end cover 21. The electrode terminal 211 may be configured to electrically connect to the electrode assembly 23 to output or input electrical energy of the battery cell 20. In some embodiments, a pressure relief mechanism 212 configured to relieve internal pressure when the internal pressure or a temperature of the battery cell 20 reaches a threshold is further arranged on the end cover 21. The end cover 21 may also be made of various materials, such as copper, iron, aluminum, stainless steel, aluminum alloy, and plastic, which are not particularly limited in the embodiments of the present application. In some embodiments, an insulating member may also be arranged on an inner side of the end cover 21. The insulating member can be configured to isolate electrical connection members in the shell 22 from the end cover 21, reducing a short-circuit risk. For example, the insulating member may be made of plastic, rubber, or the like.

The shell 22 is an assembly configured to form an internal environment of the battery cells 20 together with the end cover 21, where the formed internal environment may be configured to accommodate the electrode assembly 23, an electrolyte, and other components. The shell 22 and the end cover 21 may be separate components, an opening may be provided in the shell 22, and the end cover 21 covers the opening to form the internal environment of the battery cell 20. Without limitation, the end cover 21 and the shell 22 may also be integrated. Specifically, the end cover 21 and the shell 22 may form a shared connection surface before other components are arranged inside the shell, and then the end cover 21 covers the shell 22 when inside of the shell 22 needs to be defined. The shell 22 may be of various shapes and sizes, such as a rectangular shape, a cylindrical shape, and a hexagonal prism shape. Specifically, the shape of the shell 22 may be determined based on a specific shape and size of an electrode assembly 23. The shell 22 may be made of various materials, such as copper, iron, aluminum, stainless steel, aluminum alloy, and plastic, which are not particularly limited in the embodiments of the present application.

The electrode assembly 23 is a component in the battery cell 20 that undergoes electrochemical reactions. The shell 22 may include one or more electrode assemblies 23. The electrode assembly 23 includes a positive electrode member, a negative electrode member, and an isolating member. During charge and discharge of the battery cell, active ions (for example, lithium ions) are intercalated and deintercalated back and forth between the positive electrode member and the negative electrode member. The isolating member is disposed between the positive electrode member and the negative electrode member, and may play a role in preventing a short circuit between the positive electrode member and the negative electrode member while allowing the active ions to pass through.

In some embodiments, the positive electrode member may be a positive electrode plate, and the positive electrode plate includes a positive electrode current collector and a positive electrode active material arranged on at least one surface of the positive electrode current collector.

In some embodiments, the negative electrode member may be a negative electrode plate, and the negative electrode plate includes a negative electrode current collector and a negative electrode active material arranged on at least one surface of the negative electrode current collector.

In some implementations, the isolating member is a separator. A type of the separator is not particularly limited in the present application, and any well-known separator with a porous structure having good chemical stability and mechanical stability may be selected.

In some implementations, the electrode assembly 23 is of a wound structure. The positive electrode plate and the negative electrode plate are wound into the wound structure.

In some implementations, the electrode assembly 23 is of a stacked structure.

In some implementations, the power distribution apparatus 100 may be a set of a plurality of electrical members. The electrical member may be, but is not limited to, a component such as a relay, a fuse, a resistor, or a current sensor. For example, the power distribution apparatus 100 may be a high-voltage power distribution box, and the high-voltage power distribution box may refer to a high-voltage power distribution unit (PDU) configured to be responsible for power distribution and management of the high-voltage circuit in the power consuming device, for example, applied to a new energy vehicle. The PDU is responsible for power distribution and management in a high-voltage circuit of the new energy vehicle, providing functions such as charge and discharge control, electric control on a high-voltage component, circuit overload and short-circuit protection, high-voltage sampling, and low-voltage control for the entire vehicle, and protecting and monitoring running of the high-voltage circuit. For example, the PDU may be configured to control electric energy allocation and management of the battery 1100 to the controller 1200 and the motor 1300, so as to assist in running of the vehicle 1000. The power distribution apparatus 100 may be further configured to control charge and discharge of the battery cell 20 in the battery 1100. The high-voltage power distribution box may alternatively refer to a component applied to a battery 1100 and configured to control charge and discharge of the battery 1100, for example, a battery 1100 disconnect unit (BDU). The BDU is a system for controlling charge and discharge of the battery 1100, and a high-voltage power distribution box specifically designed for the battery 1100. For example, the BDU may control charge and discharge of the battery cell 20.

In some implementations, a power distribution apparatus 100 may be configured to control electric energy allocation and management of the battery 1100 to the controller 1200 and the motor 1300, so as to assist in running of the vehicle 1000. The power distribution apparatus 100 may be further configured to control charge and discharge of the battery cell 20 in the battery 1100. The power distribution apparatus 100 may be mounted inside the box 10, or may be mounted outside the box 10.

With reference to FIG. 5, FIG. 6, and FIG. 7, in an embodiment of the present application, a power distribution apparatus 100 is provided. The power distribution apparatus 100 includes a first electrical member 110 and a second electrical member 120, where the first electrical member 110 includes a first connection terminal 111, and the first connection terminal 111 is configured to electrically connect the first electrical member 110 to another electrical member; and a first gap 1001 is formed between the second electrical member 120 and the first electrical member 110, where the first connection terminal 111 is located outside the first gap 1001.

The power distribution apparatus 100 generally includes a plurality of electrical members, and the first electrical member 110 may be an electrical member or an electrical module integrated by a plurality of electrical members in the power distribution apparatus 100. For example, the first electrical member 110 may be, but is not limited to, a component such as a relay, a fuse, a circuit, or a current sensor.

The first connection terminal 111 may be a component that is in the first electrical member 110 and that is configured to electrically connect to another electrical member. The first electrical member 110 may be electrically connected to another electrical member by using a first electrical connection member 151, where one end of the first electrical connection member 151 is electrically connected to the another electrical member, and the other end of the first electrical connection member 151 is electrically connected to the first connection terminal 111, thereby implementing an electrical connection between the first electrical member 110 and the another electrical member. The another electrical member herein may be the second electrical member 120, or may be another electrical member different from the first electrical member 110 and the second electrical member 120, or may be an electrical member different from the power distribution apparatus 100. To meet an electricity conduction requirement, the first connection terminal 111 is made of an electrically conductive material, for example, copper or aluminum.

The second electrical member 120 may be an electrical member different from the first electrical member 110 in the power distribution apparatus 100. The second electrical member 120 may be an electrical member or an electrical module integrated by a plurality of electrical members in the power distribution apparatus 100. For example, the second electrical member 120 may be, but is not limited to, a component such as a relay, a fuse, a circuit, or a current sensor.

That the first gap 1001 is formed between the first electrical member 110 and the second electrical member 120 may be understood as that, the first electrical member 110 is adjacent to the second electrical member 120, and the first electrical member 110 and the second electrical member 120 are disposed at an interval, so that a gap is formed between the first electrical member 110 and the second electrical member 120. The gap is the first gap 1001.

That the first connection terminal 111 is located outside the first gap 1001 may be understood as that, the first connection terminal 111 is staggered from the first gap 1001 in space, the first connection terminal 111 does not occupy the space of the first gap 1001, and the first connection terminal 111 is located outside the gap formed between the first electrical member 110 and the second electrical member 120. For example, a lateral portion of the first electrical member 110 opposite to the second electrical member 120 is a first lateral portion 113, and the first connection terminal 111 may be located on a lateral portion of the first electrical member 110 adjacent to the first lateral portion 113, or may be located on a lateral portion of the first electrical member 110 facing away from the second electrical member 120, so that the first connection terminal 111 is staggered from the first gap 1001. When the first electrical connection member 151 is electrically connected to the first connection terminal 111, because the first connection terminal 111 is located outside the first gap 1001, a connection operation between the first electrical connection member 151 and the first connection terminal 111 may be performed outside the first gap 1001, that is, a connection operation space required by the first connection terminal 111 does not need to be disposed in the first gap 1001. In this way, a spacing between the first electrical member 110 and the second electrical member 120 can be reduced.

In the power distribution apparatus 100 of this embodiment of the present application, the first gap 1001 is formed between the first electrical member 110 and the second electrical member 120, and the first connection terminal 111 of the first electrical member 110 is located outside the first gap 1001, so that a connection operation space required by the first connection terminal 111 is located outside the first gap 1001, thereby reducing the spacing between the first electrical member 110 and the second electrical member 120, and improving the structural compactness of the entire power distribution apparatus 100, which is beneficial to reducing the outline size of the entire power distribution apparatus 100, and is also beneficial to improving performance of a power consuming device and reducing costs of the power consuming device.

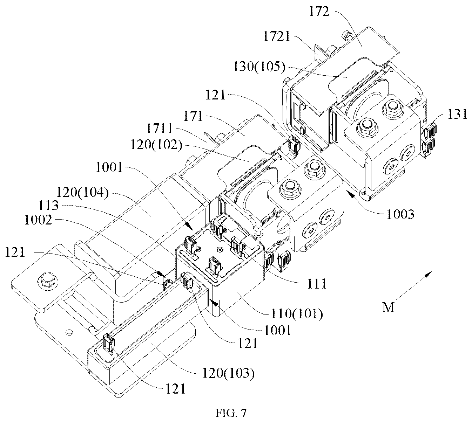

In an embodiment of the present application, with reference to FIG. 7, the second electrical member 120 includes a second connection terminal 121, the second connection terminal 121 is configured to electrically connect the second electrical member 120 to another electrical member, and the second connection terminal 121 is located outside the first gap 1001.

The second connection terminal 121 may be a component that is in the second electrical member 120 and that is configured to electrically connect to another electrical member. The second electrical member 120 may be electrically connected to another electrical member by using the first electrical connection member 151. One end of the first electrical connection member 151 is electrically connected to the another electrical member, and the other end of the first electrical connection member 151 is electrically plugged into the second connection terminal 121, thereby implementing an electrical connection between the second connection terminal 121 and the another electrical member, and further implementing an electrical connection between the second electrical member 120 and the another electrical member. The another electrical member herein may be the first electrical member 110, or may be another electrical member different from the first electrical member 110 and the second electrical member 120, or may be an electrical member different from the power distribution apparatus 100. To meet an electricity conduction requirement, each second connection terminal 121 is made of an electrically conductive material, for example, copper or aluminum. A structure of the second connection terminal 121 may be the same as or different from that of the first connection terminal 111.

That the second connection terminal 121 is located outside the first gap 1001 may be understood as that, the second connection terminal 121 is staggered from the first gap 1001 in space, the second connection terminal 121 does not occupy the space of the first gap 1001, and the second connection terminal 121 is located outside the gap formed between the first electrical member 110 and the second electrical member 120. For example, a lateral portion of the second electrical member 120 opposite to the first electrical member 110 is a second lateral portion, and the second connection terminal 121 may be located on a lateral portion of the second electrical member 120 adjacent to the second lateral portion, or may be located on a lateral portion of the second electrical member 120 facing away from the first electrical member 110, so that the second connection terminal 121 is staggered from the first gap 1001. A structure of the second connection terminal 121 may be the same as or different from that of the first connection terminal 111.

By using the technical solution of this embodiment, a connection operation space required by the second connection terminal 121 may not occupy the first gap 1001. In this way, a spacing between the second electrical member 120 and the first electrical member 110 may be set to be small, so that the power distribution apparatus 100 has better structural compactness and a smaller overall size, which is more beneficial to improving performance of a power consuming device and reducing costs of the power consuming device.

In an embodiment of the present application, with reference to FIG. 7, at least two second electrical members 120 are disposed, the first gap 1001 is formed between each of the second electrical members 120 and the first electrical member 110, and the first connection terminal 111 is located outside each first gap 1001; and/or at least one second connection terminal 121 is located outside each first gap 1001.

That the at least two second electrical members 120 are disposed may be understood as that, the quantity of second electrical members 120 may be, but is not limited to, two, three, and four.

That the first gap 1001 is formed between each of the second electrical members 120 and the first electrical member 110 may be understood as that, a plurality of second electrical members 120 may be distributed around the first electrical member 110, and each second electrical member 120 is disposed at an interval with the first electrical member 110. A gap formed between each second electrical member 120 and the first electrical member 110 is referred to as the first gap 1001.

In an embodiment, that the first connection terminal 111 is located outside each first gap 1001 may be understood as that the first connection terminal 111 is staggered from all the first gaps 1001. In this way, the connection operation space required by the first connection terminal 111 may be staggered from all the first gaps 1001, so as not to occupy the space of any first gap 1001. In this way, a spacing between any second electrical member 120 and the first electrical member 110 may be reduced, so that the power distribution apparatus 100 has better structural compactness and a smaller overall size, which is more beneficial to improving performance of a power consuming device and reducing costs of the power consuming device.

In an embodiment, that the at least one second connection terminal 121 is located outside each first gap 1001 may be understood as that the quantity of second connection terminals 121 staggered from all the first gaps 1001 may be one, two, three, four, or more, or all the second connection terminals 121 are staggered from all the first gaps 1001. A connection operation space required by the at least one second connection terminal 121 may not occupy all the first gaps 1001, so that a spacing between the second electrical member 120 and the first electrical member 110 may be set to be small, so that the power distribution apparatus 100 has better structural compactness and a smaller overall size, which is more beneficial to improving performance of a power consuming device and reducing costs of the power consuming device.

In an embodiment, the first connection terminal 111 is located outside each first gap 1001, and the at least one second connection terminal 121 is located outside all the first gaps 1001. In this way, the first connection terminal 111 and the at least one second connection terminal 121 are both staggered from all the first gaps 1001. In this way, a spacing between the second electrical member 120 and the first electrical member 110 may be set to be small, so that the power distribution apparatus 100 has better structural compactness and a smaller overall size, which is more beneficial to improving performance of a power consuming device and reducing costs of the power consuming device.

By using the technical solution of this embodiment, a spacing between the second electrical member 120 and the first electrical member 110 may be reduced, so that the power distribution apparatus 100 has better structural compactness and a smaller overall size, which is more beneficial to improving performance of a power consuming device and reducing costs of the power consuming device.

In an embodiment of the present application, with reference to FIG. 7, a second gap 1002 is formed between two adjacent second electrical members 120, and the first connection terminal 111 is located outside each second gap 1002; and/or the at least one second connection terminal 121 is located outside each second gap 1002.

Two adjacent second electrical members 120 are disposed at an interval, and a gap formed between the two adjacent second electrical members 120 is referred to as the second gap 1002.

In an embodiment, that a second gap 1002 is formed between two adjacent second electrical members 120, and the first connection terminal 111 is located outside the second gap 1002 may be understood as that, the first connection terminal 111 is staggered from the second gap 1002, and a connection operation space required by the first connection terminal 111 is also staggered from the second gap 1002. In this way, a spacing between two adjacent second electrical members 120 may be set to be small, so that the power distribution apparatus 100 has good structural compactness and a small overall size, which is beneficial to improving performance of a power consuming device and reducing costs of the power consuming device.

In an embodiment, that a second gap 1002 is formed between two adjacent second electrical members 120 and the at least one second connection terminal 121 is located outside each second gap 1002 may be understood as that the quantity of second connection terminals 121 located outside all second gaps 1002 may be one, two, three, or more, that is, one part of second connection terminals 121 are located outside the second gaps 1002, and the other part of second connection terminals 121 are located inside the second gaps 1002; or all the second connection terminals 121 are located outside the second gaps 1002; and the at least one second connection terminal 121 is staggered from all the second gaps 1002 in space, the at least one second connection terminal 121 occupies no space of the second gaps 1002, the at least one second connection terminal 121 is located outside the gap formed between the two adjacent second electrical members 120, and the connection operation space required by the at least one second connection terminal 121 is also staggered from the second gaps 1002. In this way, a spacing between two adjacent second electrical members 120 may be set to be small, so that the power distribution apparatus 100 has better structural compactness and a smaller overall size, which is more beneficial to improving performance of a power consuming device and reducing costs of the power consuming device.

In an embodiment, a second gap 1002 is formed between two adjacent second electrical members 120, and the first connection terminal 111 is located outside each second gap 1002; the at least one second connection terminal 121 is located outside each second gap 1002; and connection operation spaces required by the first connection terminals 111 located outside all second gaps 1002 are staggered from the second gaps 1002, and connection operation spaces required by the second connection terminals 121 located outside all second gaps 1002 are staggered from the second gaps 1002. In this way, a spacing between two adjacent second electrical members 120 may be set to be small, so that the power distribution apparatus 100 has better structural compactness and a smaller overall size, which is more beneficial to improving performance of a power consuming device and reducing costs of the power consuming device.

By using the technical solution of this embodiment, connection operation spaces required by the first connection terminals 111 located outside all second gaps 1002 are staggered from the second gaps 1002, and connection operation spaces required by the second connection terminals 121 located outside all second gaps 1002 are staggered from the second gaps 1002. At least one of the two manners can enable a spacing between two adjacent second electrical members 120 to be set to be small, so that the power distribution apparatus 100 has better structural compactness and a smaller overall size, which is more beneficial to improving performance of a power consuming device and reducing costs of the power consuming device.

In an embodiment of the present application, with reference to FIG. 7, the first connection terminal 111 and the at least one second connection terminal 121 are located on a same side of the first electrical member 110 and the second electrical member 120.

It may be understood that, the first connection terminal 111 and one part of second connection terminals 121 are located on a same side of the first electrical member 110 and the second electrical member 120, and the other part of second connection terminals 121 are located on other sides of the second electrical member 120; or the first connection terminal 111 and all second connection terminals 121 are located on a same side of the first electrical member 110 and the second electrical member 120. Specifically, if a second electrical member 120 is disposed on each of the left side, the right side, and the rear side of the first electrical member 110, the first connection terminal 111 is located on an upper side of the first electrical member 110, and at least some second connection terminals 121 are located on an upper side of the second electrical member 120. Certainly, in another embodiment, the first connection terminal 111 may alternatively be located on a lower side of the first electrical member 110, and at least some second connection terminals 121 are also located on a lower side of the second electrical member 120.

By using the technical solution of this embodiment, connection operation spaces required by the first connection terminal 111 and the at least one second connection terminal 121 are centralized on a same side of the first electrical member 110 and the second electrical member 120, which is also beneficial to reducing an overall size of the power distribution apparatus 100, and beneficial to improving performance of the power consuming device and reducing costs of the power consuming device. In addition, an electrical connection operation may be performed on the first connection terminal 111 and the second connection terminal 121 on a same side of the first electrical member 110 and the second electrical member 120, which also facilitates assembly of the power distribution apparatus 100.

In an embodiment of the present application, with reference to FIG. 7, the power distribution apparatus 100 further includes a third electrical member 130, the third electrical member 130 and the first electrical member 110 are located on different sides of the second electrical member 120, a third gap 1003 is formed between the second electrical member 120 and the third electrical member 130, and the at least one second connection terminal 121 is located outside the third gap 1003.

The third electrical member 130 may be an electrical member different from the first electrical member 110 and the second electrical member 120. The third electrical member 130 may be an electrical member or an electrical module integrated by a plurality of electrical members in the power distribution apparatus 100. For example, the third electrical member 130 may be, but is not limited to, a component such as a relay, a fuse, a circuit, or a current sensor.

That the third electrical member 130 and the first electrical member 110 are located on different sides of the second electrical member 120 may be understood as that, the third electrical member 130 is located on a side of the second electrical member 120, and the third electrical member 130 is located on another side of the second electrical member 120 different from a side on which the first electrical member 110 is disposed.

That the third gap 1003 is formed between the second electrical member 120 and the third electrical member 130 may be understood as that, the second electrical member 120 is adjacent to the third electrical member 130, and the second electrical member 120 and the third electrical member 130 are disposed at an interval, so that a gap is formed between the second electrical member 120 and the third electrical member 130. The gap is the third gap 1003.

That the at least one second connection terminal 121 is located outside the third gap 1003 may be understood that, one part of second connection terminals 121 are located outside the third gaps 1003, and the other part of second connection terminals 121 are located inside the third gaps 1003; or all the second connection terminals 121 are located outside the third gaps 1003; and the at least one second connection terminal 121 is staggered from the third gap 1003 in space, so that the at least one second connection terminal 121 does not occupy the space of the third gap 1003, and the at least one second connection terminal 121 is located outside the space between the second electrical member 120 and the third electrical member 130. For example, a lateral portion of the second electrical member 120 opposite to the third electrical member 130 is a third lateral portion, and the second connection terminal 121 may be located on a lateral portion of the second electrical member 120 adjacent to the third lateral portion, or may be located on a lateral portion of the second electrical member 120 facing away from the third electrical member 130, so that the second connection terminal 121 is staggered from the third gap 1003. The second lateral portion and the third lateral portion may be disposed adjacent to each other, or may be disposed opposite to each other.

By using the technical solution of this embodiment, a connection operation space required by the at least one second connection terminal 121 may not occupy the third gap 1003. In this way, a spacing between the second electrical member 120 and the third electrical member 130 may be set to be small, so that the power distribution apparatus 100 has better structural compactness and a smaller overall size, which is more beneficial to improving performance of a power consuming device and reducing costs of the power consuming device.

In an embodiment of the present application, with reference to FIG. 7, the third electrical member 130 includes a third connection terminal 131, the third connection terminal 131 is configured to electrically connect the third electrical member 130 to another electrical member, and the third connection terminal 131 is located outside the third gap 1003.

The third connection terminal 131 may be a component that is in the third electrical member 130 and that is configured to electrically connect to another electrical member. The third electrical member 130 may be electrically connected to another electrical member by using the first electrical connection member 151. One end of the first electrical connection member 151 is electrically connected to the another electrical member, and the other end of the first electrical connection member 151 is electrically plugged into the third connection terminal 131, thereby implementing an electrical connection between the third connection terminal 131 and the another electrical member, and further implementing an electrical connection between the third electrical member 130 and the another electrical member. The another electrical member herein may be the first electrical member 110 or the second electrical member 120, or may be another electrical member different from the first electrical member 110 and the second electrical member 120, or may be an electrical member different from the power distribution apparatus 100. To meet an electricity conduction requirement, the third connection terminal 131 is made of an electrically conductive material, for example, copper or aluminum. A structure of the third connection terminal 131 may be the same as or different from that of the first connection terminal 111.

That the third connection terminal 131 is located outside the third gap 1003 may be understood as that, the third connection terminal 131 is staggered from the third gap 1003 in space, the third connection terminal 131 does not occupy the space of the third gap 1003, and the third connection terminal 131 is located outside the space between the second electrical member 120 and the third electrical member 130. For example, a lateral portion of the third electrical member 130 opposite to the second electrical member 120 is a fourth lateral portion, and the third connection terminal 131 may be located on a lateral portion of the third electrical member 130 adjacent to the fourth lateral portion, or may be located on a lateral portion of the third electrical member 130 facing away from the fourth lateral portion, so that the third connection terminal 131 is staggered from the third gap 1003. A structure of the third connection terminal 131 may be the same as or different from that of the first connection terminal 111.

By using the technical solution of this embodiment, a connection operation space required by the third connection terminal 131 may not occupy the third gap 1003. In this way, a spacing between the third electrical member 130 and the second electrical member 120 may be set to be small, so that the power distribution apparatus 100 has better structural compactness and a smaller overall size, which is more beneficial to improving performance of a power consuming device and reducing costs of the power consuming device.

In an embodiment of the present application, with reference to FIG. 7, the third connection terminal 131 and the at least one second connection terminal 121 are located on a same side of the second electrical member 120 and the third electrical member 130.

That the third connection terminal 131 and the at least one second connection terminal 121 are located on a same side of the second electrical member 120 and the third electrical member 130 may be understood as that, the third connection terminal 131 and the at least one second connection terminal 121 are located on a same side of the second electrical member 120 and the third electrical member 130. For example, when the third electrical member 130 is located on a left side of the second electrical member 120, the third connection terminal 131 is located on an upper side of the third electrical member 130, and the at least one second connection terminal 121 is located at on upper side of the second electrical member 120. Certainly, in another embodiment, the third connection terminal 131 is located on a lower side of the third electrical member 130, and the at least one second connection terminal 121 is also located on a lower side of the second electrical member 120; or the third connection terminal 131 is located on a front side of the third electrical member 130, and the at least one second connection terminal 121 is also located on a front side of the second electrical member 120; or the third connection terminal 131 is located on a rear side of the third electrical member 130, and the at least one second connection terminal 121 is also located on a rear side of the second electrical member 120.

By using the technical solution of this embodiment, connection operation spaces required by the third connection terminal 131 and the at least one second connection terminal 121 are centralized on a same side of the second electrical member 120 and the third electrical member 130, which is also beneficial to reducing an overall size of the power distribution apparatus 100. An electrical connection operation is performed on the second connection terminal 121 and the third connection terminal 131 on a same side of the second electrical member 120 and the third electrical member 130, which also facilitates assembly of the power distribution apparatus 100.

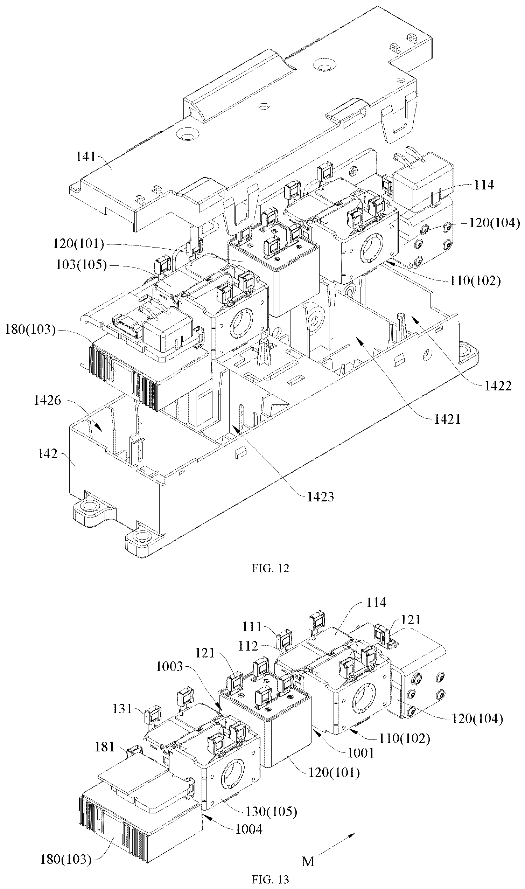

In an embodiment, with reference to FIG. 12 and FIG. 13, the power distribution apparatus 100 may further include a fourth electrical member 180, the fourth electrical member 180 and the second electrical member 120 are located on different sides of the third electrical member 130, a fourth gap 1004 is formed between the fourth electrical member 180 and the third electrical member 130, and the third connection terminal 131 is located outside the fourth gap 1004. In this way, a spacing between the third electrical member 130 and the fourth electrical member 180 may be reduced, to improve structural compactness. In another embodiment, the fourth electrical member 180 includes a fourth connection terminal 181, the fourth connection terminal 181 is configured to electrically connect the fourth electrical member 180 to another electrical member, and the fourth connection terminal 181 is located outside the fourth gap 1004. In this way, a spacing between the third electrical member 130 and the fourth electrical member 180 may be further reduced, to improve structural compactness. By analogy, the power distribution apparatus 100 further includes a fifth electrical member, a sixth electrical member, a seventh electrical member, and the like. That is, a connection terminal led out from an electrical member in the power distribution apparatus 100 may be disposed outside a gap between electrical members, helping improve structural compactness.

In an embodiment of the present application, with reference to FIG. 7, the first electrical member 110, at least one second electrical member 120, and at least one third electrical member 130 are in a linear arrangement.

The first electrical member 110, the at least one second electrical member 120, and the at least one third electrical member 130 are in a linear arrangement in a direction (referring to a direction indicated by an arrow M), so that the first gaps 1001, at least some second gaps 1002, and at least some third gaps 1003 are also in a linear arrangement.

By using the technical solution of this embodiment, the first electrical member 110, the second electrical member 120, and the third electrical member 130 are simply arranged, which may facilitate disposition of the first connection terminal 111, the second connection terminal 121, and the third connection terminal 131, facilitate assembly and manufacturing of the power distribution apparatus 100, and is also beneficial to reducing an overall size of the power distribution apparatus 100 in a direction perpendicular to a linear arrangement direction, thereby achieving better overall structural compactness.

In an embodiment, with reference to FIG. 12 and FIG. 13, the first electrical member 110, the second electrical member 120, the third electrical member 130, and the fourth electrical member 180 are in a linear arrangement. In this way, the electrical members in the power distribution apparatus 100 are simply arranged, which helps improve the structural compactness. In addition, all connection terminals led out from the electrical members are located on a same side of all the electrical members. In this way, all the connection terminals are located outside all gaps between the electrical members, thereby further improving the structural compactness. In addition, an electrical connection operation on the connection terminals is also facilitated, which helps improve the production efficiency of the power distribution apparatus 100.

In an embodiment of the present application, with reference to FIG. 7, the first electrical member 110 has a first lateral portion 113 opposite to the second electrical member 120, and the first connection terminal 111 is located on a lateral portion of the first electrical member 110 adjacent to the first lateral portion 113.

The first lateral portion 113 may be a lateral portion of the first electrical member 110 opposite to the second electrical member 120, and a first gap 1001 is formed between the first lateral portion 113 and the second electrical member 120.

The first connection terminal 111 is located on a lateral portion of the first electrical member 110 adjacent to the first lateral portion 113, so that the first connection terminal 111 is staggered from the first gap 1001, that is, the first connection terminal 111 is located outside the first gap 1001, and the first connection terminal 111 is adjacent to the first gap 1001.

By using the technical solution of this embodiment, the first connection terminal 111 is located on a lateral portion of the first electrical member 110 adjacent to the first lateral portion 113. In this way, a connection operation space required by the first connection terminal 111 is located on a side of an arrangement direction of the first electrical member 110 and the second electrical member 120, and the connection operation space does not overlap in the arrangement direction of the first electrical member 110 and the second electrical member 120, so that a size of the power distribution apparatus 100 in the arrangement direction of the first electrical member 110 and the second electrical member 120 can be reduced, which helps improve structural compactness.

In an embodiment of the present application, with reference to FIG. 7, a plurality of first connection terminals 111 are disposed, and at least two of the first connection terminals 111 are located on a same side of the first electrical member 110.

That the plurality of first connection terminals 111 are disposed may be understood as that, the quantity of first connection terminals 111 may be, but is not limited to, two, three, four, or more.

That the at least two of the first connection terminals 111 are located on the same side of the first electrical member 110 may be understood that one part of the first connection terminals 111 are located on a same side of the first electrical member 110, and the other part of the first connection terminals 111 are located on other sides of the first electrical member 110; or all the first connection terminals 111 are located on a same side of the first electrical member 110. For example, 4 first connection terminal 111 is located on an upper side of the first electrical member 110.

By using the technical solution of this embodiment, connection operation spaces required by the at least two first connection terminals 111 are centralized on a same side of the first electrical member 110, so that the at least two first connection terminals 111 are staggered from the first gaps 1001, which is beneficial to reducing a spacing between the first electrical member 110 and the second electrical member 120, thereby reducing an overall size of the power distribution apparatus 100, and achieving better overall structural compactness. In addition, a connection operation may be performed on the at least two first connection terminals 111 on a same side of the first electrical member 110, to facilitate an electrical connection operation on the power distribution apparatus 100.

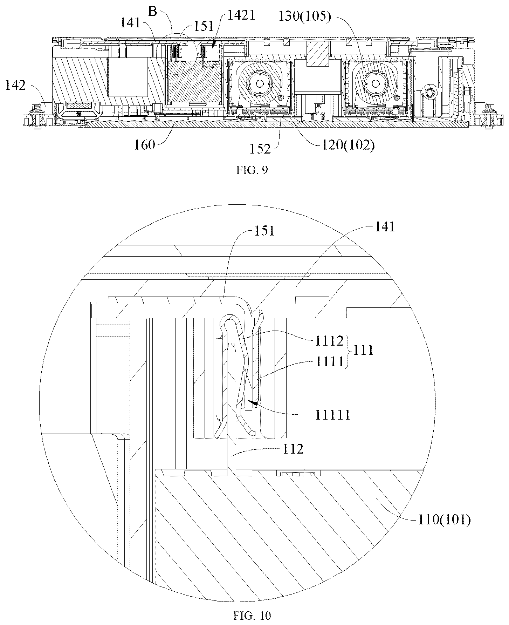

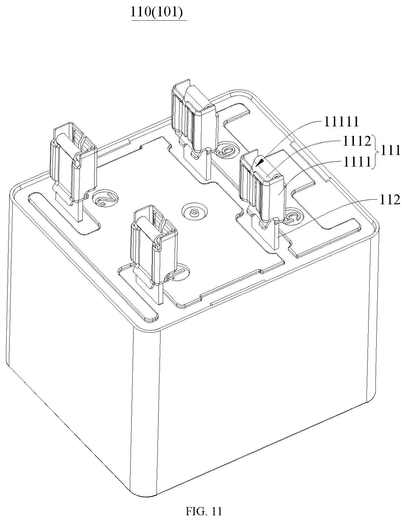

In an embodiment of the present application, with reference to FIG. 9, FIG. 10, and FIG. 11, the power distribution apparatus 100 further includes a first electrical connection member 151, the first electrical connection member 151 has a first end and a second end, the first end is configured to connect to another electrical member different from the first electrical member 110, and the second end is configured to electrically plug into the first connection terminal 111.

The first electrical connection member 151 may be a component configured to electrically connect the first electrical member 110 to another electrical member. The first electrical connection member 151 is made of an electrically conductive material, for example, copper or aluminum. For example, the first electrical connection member 151 is a copper bar.

The first end may be an end that is in the first electrical connection member 151 and that is connected to another electrical member different from the first electrical member 110. The second end may be an end that is in the first electrical connection member 151 and that is electrically plugged into the first connection terminal 111. The first end of the first electrical connection member 151 is electrically connected to another electrical member different from the first electrical member 110, and the second end of the first electrical connection member 151 is electrically plugged into the first connection terminal 111, thereby implementing electrically conductive between the first electrical member 110 and the another electrical member. The another electrical member herein may be the second electrical member 120 or the third electrical member 130, or may be another electrical member different from the first electrical member 110, the second electrical member 120, and the third electrical member 130. There may be a plurality of first electrical connection members 151. Electrically conductive between the second electrical member 120 and the third electrical member 130, between the second electrical member 120 and another electrical member different from the first electrical member 110, the second electrical member 120, and the third electrical member 130, and between the third electrical member 130 and another electrical member different from the first electrical member 110, the second electrical member 120, and the third electrical member 130 may be implemented by using the first electrical connection members 151.

By using the technical solution of this embodiment, the first electrical connection member 151 may implement communication between the first electrical member 110 and another electrical member, and the first electrical connection member 151 and the first connection terminal 111 are electrically connected in a manner of electrical plugging. The connection manner is simple, and assembly of the power distribution apparatus 100 is convenient.

In an embodiment of the present application, with reference to FIG. 9, FIG. 10, and FIG. 11, the first connection terminal 111 includes a body 1111 and an elastic member 1112, the body 1111 is constructed with a plugging hole 11111, the elastic member 1112 is located in the plugging hole 11111, the second end is inserted into the plugging hole 11111, and the second end elastically butts against the elastic member 1112, to elastically clamp the second end in the plugging hole 11111.

The body 1111 may refer to a main part of the first connection terminal 111. The body 1111 is provided with a plugging hole 11111, and the plugging hole 11111 is used for insertion of the second end and provides a mounting space for the elastic member 1112. In a state in which the second end of the first electrical connection member 151 is inserted into the plugging hole 11111, the second end elastically butts against the elastic member 1112, and the elastic member 1112 may provide a butting force to the second end, so that the second end is elastically snapped in the plugging hole 11111, plugging stability between the first electrical connection member 151 and the first connection terminal 111 is good, and the electrical connection is more stable and reliable.

The elastic member 1112 may be a part having an elastic deformation capability, and the elastic member 1112 is made of an electrically conductive material, such as copper or aluminum, to satisfy a requirement for electrically conductive. The elastic member 1112 and the body 1111 may be of an integral structure or may be of a split structure, and materials of the elastic member 1112 and the body 1111 may be the same or may be different. For example, in a state in which the second end of the first electrical connection member 151 is inserted into the plugging hole 11111, the elastic member 1112 pushes the second end to butt against a wall surface of the plugging hole 11111 opposite to the elastic member 1112, thereby elastically clamping the second end. The elastic member 1112 may be an electrically conductive spring sheet.

By using the technical solution of this embodiment, the second end is elastically snapped in the plugging hole 11111, the plugging stability between the first electrical connection member 151 and the first connection terminal 111 is good, and the electrical connection is more stable and reliable. In addition, the structure of the first connection terminal 111 is simple, the second end is elastically snapped in the plugging hole 11111 by using the elastic member 1112, and the first electrical connection member 151 can be plugged into the first connection terminal 111 for a plurality of times, to facilitate assembly and maintenance.

In an embodiment of the present application, the second end has a sheet shape.
the second end has a flat shape.

By using the technical solution of this embodiment, the second end has a sheet shape. In this way, after the second end is inserted into the plugging hole 11111, the second end and the elastic member 1112 may have a large butting area, so that the plugging stability between the first electrical connection member 151 and the first connection terminal 111 is better, and the electrical connection is more stable and reliable.

In an embodiment of the present application, with reference to FIG. 5, FIG. 6, FIG. 7, and FIG. 9, the power distribution apparatus 100 further includes a first shell cover 141 and a mounting base 142, the first shell cover 141 is mounted on the mounting base 142, the first shell cover 141 and the mounting base 142 define a mounting space, the first electrical member 110 and the second electrical member 120 are located in the mounting space, the first electrical connection member 151 is mounted on the first shell cover 141, and a plugging opening of the first connection terminal 111 is disposed toward the first shell cover 141.

The first shell cover 141 is connected to the mounting base 142 to form at least a part of a housing 140 of the power distribution apparatus 100, and the first shell cover 141 may be connected to the mounting base 142 in a manner such as covering, bolting, or bonding. The mounting space may refer to a space that is formed by the first shell cover 141 and the mounting base 142 and that is used for accommodating the first electrical member 110 and the second electrical member 120. For example, the first shell cover 141 and the mounting base 142 may jointly define a mounting space. The mounting space provides mounting space for the electrical member of the power distribution apparatus 100. The first shell cover 141 and the mounting base 142 may isolate the electrical member from the external environment, thereby protecting the electrical member. The mounting base 142 may be a hollow structure with one end open. The first shell cover 141 may be a plate-shaped structure. The first shell cover 141 covers an open side of the mounting base 142, so that the first shell cover 141 and the mounting base 142 jointly define the mounting space. The first shell cover 141 and the mounting base 142 may each be a hollow structure with one side open, and the open side of the first shell cover 141 covers the open side of the mounting base 142. Certainly, the housing 140 formed by the first shell cover 141 and the mounting base 142 may be in various shapes, such as a cylinder, and a cuboid. The first shell cover 141 and the mounting base 142 are each made of an insulating material, for example, insulating plastic such as polypropylene (PP), polyethylene (PE), or polyvinylchlorid (PVC), so as to play a role in insulating and protecting the first electrical member 110 and the second electrical member 120.

That the first electrical connection member 151 is mounted on the first shell cover 141 may be understood as that, the first electrical connection member 151 is connected to the first shell cover 141. Specifically, the first electrical connection member 151 may be fixed on the first shell cover 141 in a manner such as screwing or snap-fit.

The plugging opening of the first connection terminal 111 is disposed toward the first shell cover 141. Specifically, an opening of the plugging hole 11111 of the first connection terminal 111 is disposed opposite to the first shell cover 141. In this way, during assembly, while the first electrical member 110 is mounted on the first shell cover 141, the second end of the first electrical connection member 151 mounted on the first shell cover 141 may be inserted into the first connection terminal 111. In this way, assembly of the first electrical member 110 and the first shell cover 141 and electrical plugging of the first connection terminal 111 may be simultaneously completed, thereby helping improve assembly efficiency of the power distribution apparatus 100. Alternatively, after the first electrical member 110 and the second electrical member 120 are mounted on the mounting base 142, while the first shell cover 141 is snap-fit on the mounting base 142, because the first connection terminal 111 faces the first shell cover 141, in a process in which the first shell cover 141 is snap-fit on the mounting base 142, the second end of the first electrical connection member 151 mounted on the first shell cover 141 may be automatically electrically plugged into the first connection terminal 111. In this way, assembly of the first electrical member 110 and the first shell cover 141 and electrical plugging of the first connection terminal 111 may also be simultaneously completed, thereby helping improve assembly efficiency of the power distribution apparatus 100.

By using the technical solution of this embodiment, because the plugging opening of the first connection terminal 111 faces the first shell cover 141, during assembly of the power distribution apparatus 100, assembly of the components and electrical plugging of the first connection terminal 111 may be simultaneously completed, to help improve assembly efficiency of the power distribution apparatus 100. In addition, the second end and the first connection terminal 111 may be automatically docked. Compared with manual plugging, plugging requires a small space, which is beneficial to reducing a spacing between the first electrical member 110 and the second electrical member 120 and improving structural compactness of the power distribution apparatus 100.

In another embodiment, the plugging opening of the second connection terminal 121 may be disposed toward the first shell cover 141, to improve production efficiency. Certainly, the plugging opening of the second connection terminal 121 may not be disposed toward the first shell cover 141.

In another embodiment, the third electrical member 130 is mounted on the mounting base 142, and the plugging opening of the third connection terminal 131 may be disposed toward the first shell cover 141, to improve production efficiency. Certainly, the plugging opening of the third connection terminal 131 may not be disposed toward the first shell cover 141.

In an actual application process, when the power distribution apparatus 100 is in a working state, the first shell cover 141 may be located on the bottom of the mounting base 142, or may be located on a lateral portion of the mounting base 142, or may be located on the top of the mounting base 142, which may be specifically selected according to an actual requirement.

In an embodiment of the present application, with reference to FIG. 9 and FIG. 10, the first electrical connection member 151 is embedded in the first shell cover 141.

That the first electrical connection member 151 is embedded in the first shell cover 141 may be understood as that, the first electrical connection member 151 is located inside the first shell cover 141. In other words, the first shell cover 141 wraps the first electrical connection member 151. It should be noted that, the first end and the second end are exposed on the first shell cover 141, to facilitate electrical connection to another electrical member and the first connection terminal 111.

By using the technical solution of this embodiment, the first shell cover 141 may play a role in of protecting the first electrical connection member 151, thereby improving use reliability of the power distribution apparatus 100. In addition, the first electrical connection member 151 is located in the first shell cover 141, and overall structural compactness is good, which also helps reduce the overall size of the power distribution apparatus 100.

In an embodiment of the present application, with reference to FIG. 9 and FIG. 10, the first electrical connection member 151 and the first shell cover 141 are of an integral injection molding structure.

By using the technical solution of this embodiment, the first electrical connection member 151 and the first shell cover 141 are manufactured by using a manufacturing process of integral injection molding. The manufacturing manner is simple, and connection strength between the first electrical connection member 151 and the first shell cover 141 is good, to help improve use reliability of the power distribution apparatus 100.

In an embodiment of the present application, with reference to FIG. 12 and FIG. 13, the first electrical member 110 is a relay 110a; the relay 110a includes a switching unit 114, and the first connection terminal 111 is electrically connected to the switching unit 114; and the mounting base 142 is constructed with a first accommodating cavity 1421, and the switching unit 114 is exposed in the first accommodating cavity 1421.

The relay 110a may be an electrical member configured to control on/off of the circuit. Specifically, the relay 110a includes components such as an electromagnet, a coil, and a contact. When an input amount (such as a voltage, a current, or a temperature) of the input coil reaches a specified value, the electromagnet moves under magnetic force of the coil, and the movement of the electromagnet drives the contact to move, thereby changing an on state or an off state of the controlled circuit. The switching unit 114 may be a main component that is in the relay 110a and that performs switching control, that is, a unit including the components such as the electromagnet, the coil, and the contact in the relay 110a. The first connection terminal 111 is electrically connected to the switching unit 114, and the switching unit 114 is electrically connected to another electrical member different from the first electrical member 110 by using the first connection terminal 111.

The first accommodating cavity 1421 may be a cavity that is defined by the mounting base 142 and that is configured to accommodate the switching unit 114.

That the switching unit 114 is exposed in the first accommodating cavity 1421 may be understood as that, the switching unit 114 is not covered with the shell, but is directly exposed in the first accommodating cavity 1421. That is, a cavity wall of the first accommodating cavity 1421 may be directly used as the shell of the relay 110a. That is, the first electrical member 110 is the relay 110a from which the shell is removed, and the mounting base 142 and the shell of the relay 110a are integrated to form an integrated structure, which helps reduce manufacturing costs.

By using the technical solution of this embodiment, the switching unit 114 of the relay 110a is directly exposed in the first accommodating cavity 1421. In this way, in the power distribution apparatus 100, a space occupied by the shell of the relay 110a may be saved, thereby improving structural compactness of the power distribution apparatus 100, and helping improve performance of the power distribution apparatus 100 and reduce manufacturing costs. In addition, the relay 110a is generally a component with a large volume in the power distribution apparatus 100, and the shell of the relay 110a is omitted, so that a large space can be saved for the power distribution apparatus 100, thereby effectively improving the structural compactness of the power distribution apparatus 100.

In an embodiment, the first connection terminal 111 may be a connection terminal led out from the coil of the relay 110a, may be a connection terminal led out from the contact of the relay 110a, or may be a high-voltage sampling terminal of the relay 110a. With reference to FIG. 9, FIG. 10, and FIG. 11, the first electrical member 110 further includes a first electrically conductive member 112, and the first electrically conductive member 112 electrically connects the switching unit 114 to the body 1111. The first electrically conductive member 112 is made of an electrically conductive material, for example, copper or aluminum. For example, the first electrically conductive member 112 is a copper bar. The first electrically conductive member 112 and the body 1111 are of an integral structure or a split structure. That the first electrically conductive member 112 and the body 1111 are of an integral structure may be understood as that the first electrically conductive member 112 and the body 1111 may be processed in an integral forming manner such as integral casting or integral cutting to obtain an integral structure.

That the first electrically conductive member 112 and the body 1111 are of a split structure may be understood as that the first electrically conductive member 112 and the body 1111 may be split into two separate parts. For example, the first electrically conductive member 112 may be connected to the body 1111 in a detachable connection manner such as screwing or snap-fit; or the first electrically conductive member 112 is connected to the body 1111 in a fixing connection manner such as welding; or an end of the first electrically conductive member 112 may be inserted into the plugging hole 11111, and the elastic member 1112 pushes the end of the first electrically conductive member 112 to butt against a wall surface of the plugging hole 11111, thereby elastically clamping the first electrically conductive member 112. The end of the first electrically conductive member 112 and the second end may be located on a same side of the elastic member 1112, or may be located on two opposite sides of the elastic member 1112. In another embodiment, two elastic members 1112 are disposed in the plugging hole 11111, the second end is inserted between the two elastic members 1112, and the two elastic members 1112 clamps the second end, thereby elastically clamping the second end. A material of the first electrically conductive member 112 and a material of the body 1111 may be the same, or may be different.

In an embodiment, the second end of the first electrical connection member 151 may be electrically plugged into the first connection terminal 111 through the opening of the first accommodating cavity 1421; or the first connection terminal 111 extends out of the opening of the first accommodating cavity 1421 and is electrically plugged by the second end of the first electrical connection member 151; or the second end of the first electrical connection member 151 may be electrically plugged into the first connection terminal 111 through the cavity wall of the first accommodating cavity 1421, or the first electrically conductive member 112 passes through the cavity wall of the first accommodating cavity 1421, so that the first connection terminal 111 is located outside the first accommodating cavity 1421, to be electrically plugged by the second end of the first electrical member 110.

In an embodiment of the present application, the first electrical member 110 is a resistor, a fuse, or a current sensor; and/or the second electrical member 120 is a relay, a resistor, a fuse, or a current sensor. It may be understood that, the first electrical member 110 may be any one of a resistor, a fuse, and a current sensor in the power distribution apparatus 100. Similarly, the second electrical member 120 may be any one of a resistor, a fuse, and a current sensor in the power distribution apparatus 100.

The fuse may be an electrical member that cuts off a current by blowing when the current unusually rises to a preset value in a circuit. The fuse plays a role in protecting the safe running of the circuit.

The resistor may refer to an electrical member that is in the circuit and that has a particular resistance to flow of the current.

The current sensor may refer to a detection apparatus, which can sense information about a measured current, and can convert, according to a rule, the sensed information into an electric signal that satisfies a standard requirement. By using the technical solution of this embodiment, the structure of the power distribution apparatus 100 may be set flexibly, and processing and manufacturing are convenient.

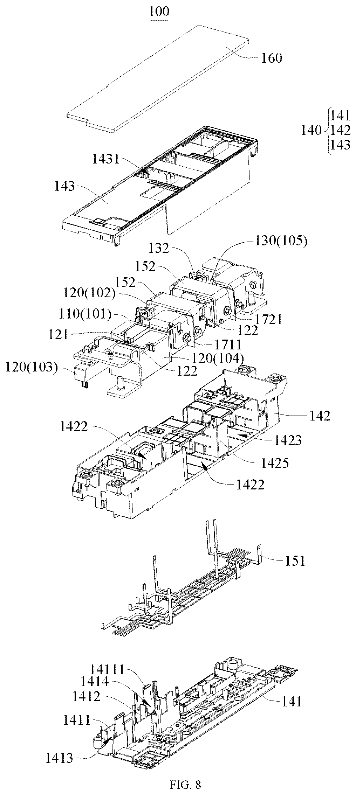

In an embodiment, with reference to FIG. 5 to FIG. 8, the mounting base 142 is further constructed with a second accommodating cavity 1422 and a third accommodating cavity 1423. The second accommodating cavity 1422 is configured to accommodate the second electrical member 120, the third accommodating cavity 1423 is configured to accommodate the third electrical member 130. The first accommodating cavity 1421, the second accommodating cavity 1422, and the third accommodating cavity 1423 each have an opening. The first electrical member 110, the second electrical member 120, and the third electrical member 130 may enter a corresponding cavity through a corresponding opening, to facilitate assembly of the power distribution apparatus 100. The first shell cover 141 is snap-fit on the outside of the mounting base 142 and seals a part of the openings. The housing 140 further includes a second shell cover 143. The second shell cover 143 is snap-fit on the mounting base 142 and seals another part of the openings, so as to insulate the electrical member in the cavity from the external environment. The second shell cover 143 and the first shell cover 141 are disposed on two opposite sides of the mounting base 142. Through this design, the structure of the entire power distribution apparatus 100 is simpler. Specifically, a partition plate is disposed in the mounting space, and the partition plate divides the mounting space into the first accommodating cavity 1421 and the second accommodating cavity 1422.

In an embodiment, the second electrical member 120 further includes a second electrically conductive member 122, and the second electrically conductive member 122 is electrically connected to the second connection terminal 121. The first electrical connection member 151 is electrically plugged into the second connection terminal 121 through the opening of the second accommodating cavity 1422; or the second connection terminal 121 extends out of the opening of the second accommodating cavity 1422 and is electrically plugged by the first electrical connection member 151; or the first electrical connection member 151 may be electrically plugged into the second connection terminal 121 through the cavity wall of the second accommodating cavity 1422, or the second electrically conductive member 122 passes through the cavity wall of the second accommodating cavity 1422, so that the second connection terminal 121 is located outside the second accommodating cavity 1422, to facilitate electrical plugging with the first electrical member 110. The second electrically conductive member 122 is made of an electrically conductive material, for example, copper or aluminum. For example, the second electrically conductive member 122 is a copper bar.

In an embodiment, the third electrical member 130 further includes a third electrically conductive member 132, and the third electrically conductive member 132 is electrically connected to the third connection terminal 131. The first electrical connection member 151 is electrically plugged into the third connection terminal 131 through the opening of the third accommodating cavity 1423; or the third connection terminal 131 extends out of the opening of the third accommodating cavity 1423 and is electrically plugged by the first electrical connection member 151; or the first electrical connection member 151 may be electrically plugged into the third connection terminal 131 through the cavity wall of the third accommodating cavity 1423, or the second electrically conductive member 122 passes through the cavity wall of the third accommodating cavity 1423, so that the third connection terminal 131 is located outside the third accommodating cavity 1423, to facilitate electrical plugging with the first electrical member 110. The third electrically conductive member 132 is made of an electrically conductive material, for example, copper or aluminum. For example, the third electrically conductive member 132 is a copper bar.

In an embodiment, the housing 140 is further provided with an insulating and thermally conductive member 160. The insulating and thermally conductive member 160 can conduct heat generated inside the power distribution apparatus 100 to the outside of the power distribution apparatus 100, thereby improving heat radiation performance of the power distribution apparatus 100. When the power distribution apparatus 100 is mounted on an external component, the insulating and thermally conductive member 160 is attached to the external component, so as to conduct heat generated inside the power distribution apparatus 100 to the external component, thereby improving heat radiation performance of the power distribution apparatus 100. The housing 140 is provided with an accommodating hole 1431 passing through the housing 140, and at least some components in the power distribution apparatus 100 are in direct contact with the insulating and thermally conductive member 160 through the accommodating hole 1431, so as to improve the heat radiation efficiency. An insulating and thermally conductive member 160 is embedded in at least one of the first shell cover 141, the mounting base 142, or the second shell cover 143, and may be specifically set according to a mounting manner of the power distribution apparatus 100. For example, the second shell cover 143 is provided with an accommodating hole 1431, and an insulating and thermally conductive member 160 is embedded in the second shell cover 143 and is located on a lateral portion of the second shell cover 143 that faces away from the mounting base 142. The insulating and thermally conductive member 160 may be manufactured by using a component having good thermal conduction and insulating properties, such as ceramic or thermally conductive silicone.

In an embodiment, a first insulating and isolating member may be disposed between the first connection terminal 111 and the second connection terminal 121. The first insulating and isolating member insulates and isolates the first connection terminal 111 from the second connection terminal 121. Insulation performance between the first connection terminal 111 and the second connection terminal 121 is good, which helps reduce a spacing between the first connection terminal 111 and the second connection terminal 121, and further helps reduce a spacing between the first electrical member 110 and the second electrical member 120. Therefore, the power distribution apparatus 100 has better structural compactness and a smaller outline size. The first insulating and isolating member may be made of an insulating material, for example, insulating plastic such as rubber or silicone.

In an embodiment, at least one of the first electrical member 110, the second electrical member 120, and the third electrical member 130 may be an electrical member with a shell removed. After the electrical member has the shell removed, an overall size of the electrical member is small, which helps improve compactness of arrangement of the electrical member and reduce an overall outline size of the power distribution apparatus 100.

In an embodiment of the present application, the power distribution apparatus 100 is a high-voltage power distribution box.

It may be understood that the technical solution of the power distribution apparatus 100 described above may be applied to a high-voltage matching box. The high-voltage matching box may be but is not limited to a PDU or a BDU.

By using the technical solution of this embodiment, the high-voltage power distribution box uses the structure of the power distribution apparatus 100 described above, so that a size of the high-voltage power distribution box can be effectively reduced, and a larger mounting space can be provided for other components, thereby helping reduce difficulty in layout of a high-voltage matching box in the entire vehicle and a high-voltage power distribution box in the battery 1100. In addition, a mounting space required by the high-voltage power distribution box in the battery 1100 is small, and a larger mounting space may be provided for the battery cell 20, thereby helping improve the volume energy density of the battery 1100.

To clearly describe the technical solutions of the present application, a BDU structure is used as examples for description.

### Embodiment 1

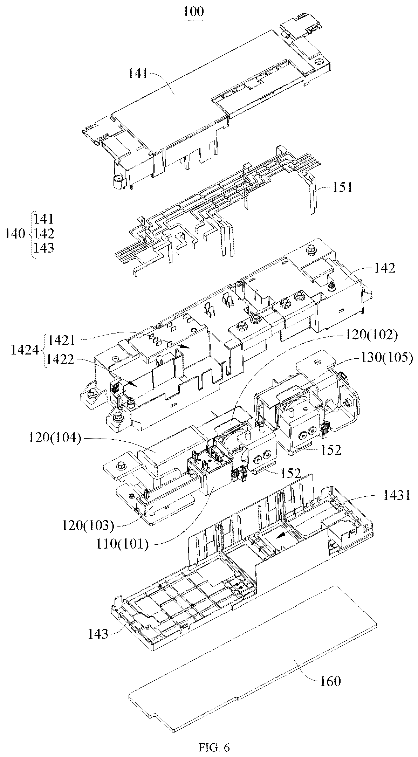

In this embodiment, with reference to FIG. 6, FIG. 7, and FIG. 8, the power distribution apparatus 100 is a BDU, and the first electrical member 110 is a pre-charge relay 101. There are three second electrical members 120, one of which is a main positive relay 102, and the other two of which are respectively a pre-charge resistor 103 and a fuse 104. The main positive relay 102 and the pre-charge resistor 103 are disposed on two opposite sides of the pre-charge relay 101. The fuse 104 is located on one of another two opposite sides of the pre-charge relay 101. First gaps 1001 are each formed between the main positive relay 102 and the pre-charge relay 101, between the pre-charge resistor 103 and the pre-charge relay 101, and between the fuse 104 and the pre-charge relay 101. Second gaps 1002 are each formed between the main positive relay 102 and the fuse 104 and between the fuse 104 and the pre-charge resistor 103. The third electrical member 130 is a main negative relay 105, the main negative relay 105 is located on a side of the main positive relay 102 that faces away from the pre-charge relay 101, and a third gap 1003 is formed between the main negative relay 105 and the main positive relay 102. In this arrangement, the BDU is long-strip-shaped, making the BDU more compact. The first connection terminal 111 may be a connection terminal led out from the coil of the pre-charge relay 101, or may be a high-voltage sampling terminal led out from the pre-charge relay 101. When the second electrical member 120 is the pre-charge resistor 103, the second connection terminal 121 may be a terminal that is led out from the pre-charge resistor 103 and that is configured to electrically connect to another electrical member, or may be a sampling terminal of the pre-charge resistor 103. When the second electrical member 120 is the fuse 104, the second connection terminal 121 may be a terminal that is led out from the fuse 104 and that is configured to control on/off of the fuse 104, may be a terminal that is led out from the fuse 104 and that is configured to electrically connect to another electrical member, or may be a sampling terminal of the fuse 104. When the second electrical member 120 is the main positive relay 102, the second connection terminal 121 may be a terminal led out from the coil of the main positive relay 102, may be a terminal led out from the contact of the main positive relay 102, or may be a high-voltage sampling terminal of the main positive relay 102. The third connection terminal 131 may be a terminal led out from the coil of the main negative relay 105, may be a terminal led out from the contact of the main negative relay 105, or may be a high-voltage sampling terminal of the main negative relay 105. In addition, the first electrical connection member 151 is a copper bar, there are a plurality of copper bars, and the plurality of copper bars electrically connect the main negative relay 105, the main positive relay 102, the pre-charge relay 101, the pre-charge resistor 103, and the fuse 104. The main positive relay 102 and the main negative relay 105 are relays with shells removed. In this way, the internal space of the power distribution apparatus 100 can be saved, which helps improve structural compactness of the power distribution apparatus 100, and helps reduce costs.

In this embodiment, with reference to FIG. 6, FIG. 7, and FIG. 8, four first connection terminals 111 led out from the pre-charge relay 101 are all located on the top of the pre-charge relay 101, and two second connection terminals 121 led out from the pre-charge resistor 103 are both located on the top of the pre-charge resistor 103, that is, the four first connection terminals 111 led out from the pre-charge relay 101 and the two second connection terminals 121 led out from the pre-charge resistor 103 are located on a same side and are located outside all the first gaps 1001, all the second gaps 1002, and all the third gaps 1003. and Four second connection terminals 121 are led out from the main positive relay 102, where two second connection terminals 121 are located on a front side of the main positive relay 102, one of the other two second connection terminals 121 is located between the main positive relay 102 and the main negative relay 105, the other is located between the pre-charge resistor 103 and the fuse 104. A second connection terminal 121 led out from the fuse 104 is located on a rear side of the fuse 104, and two second connection terminals 121 led out from the main negative relay 105 are located on a front side of the main negative relay 105. For the orientations herein, refer to orientations shown in FIG. 7.

In this embodiment, with reference to FIG. 9 to FIG. 11 together, the housing 140 of the BDU includes a first shell cover 141, a mounting base 142, and a second shell cover 143. The first shell cover 141 is snap-fit on one side of the mounting base 142. The second shell cover 143 is snap-fit on the other side of the mounting base 142 that is opposite to the first shell cover 141. The mounting base 142 is constructed with one first accommodating cavity 1421, three second accommodating cavities 1422, and one third accommodating cavity 1423. The first accommodating cavity 1421 and one of the second accommodating cavities 1422 communicate to form a fourth accommodating cavity 1424.

In this embodiment, the first shell cover 141 extends out from a surrounding edge 1411 toward a side surface of the mounting base 142. An insulating and isolating plate 1412 is disposed in the surrounding edge 1411. The insulating and isolating plate 1412 divides a cavity defined by the surrounding edge 1411 into a fifth accommodating cavity 1413 and a sixth accommodating cavity 1414. The pre-charge resistor 103 and the pre-charge relay 101 are disposed in the fifth accommodating cavity 1413 and the sixth accommodating cavity 1414 respectively. The insulating and isolating plate 1412 insulates and isolates the pre-charge resistor 103 from the pre-charge relay 101, to improve use reliability of the BDU. The surrounding edge 1411 is provided with a snap-fit fastener 14111. The pre-charge resistor 103 and the pre-charge relay 101 are fixed by using the snap-fit fastener 14111, to facilitate subsequent assembly. In a process in which the first shell cover 141 is snap-fit on the mounting base 142, the surrounding edge 1411 is inserted into the fourth accommodating cavity 1424, so that the pre-charge relay 101 is located in the first accommodating cavity 1421, the pre-charge resistor 103 is located in the second accommodating cavity 1422 communicating with the first accommodating cavity 1421, the main positive relay 102 and the fuse 104 are respectively mounted in the other two second accommodating cavities 1422, and the main negative relay 105 is mounted in the third accommodating cavity 1423.

In this embodiment, the opening of the fourth accommodating cavity 1424 and the opening of the second accommodating cavity 1422 in which the fuse 104 is loaded are respectively disposed toward two opposite sides of the mounting base 142, the opening of the fourth accommodating cavity 1424 is disposed toward the mounting base 142, and the opening of the second accommodating cavity 1422 in which the main positive relay 102 is loaded and the opening of the third accommodating cavity 1423 are disposed toward one of another two opposite sides of the mounting base 142. The first shell cover 141 is snap-fit on the mounting base 142 and seals the opening of the fourth accommodating cavity 1424. The second shell cover 143 seals, after being snap-fit on the other side of the mounting base 142, the opening of the second accommodating cavity 1422 in which the fuse 104 is loaded, the opening of the second accommodating cavity 1422 in which the main positive relay 102 is loaded, and the opening of the third accommodating cavity 1423. In this way, the electrical member inside the BDU is separated from the external environment, thereby implementing insulating and protection. The second shell cover 143 is provided with an accommodating hole 1431, a second electrical connection member 152 is connected to each of a terminal led out from the contact of the main positive relay 102 and a terminal led out from the contact of the main negative relay 105, and the two second electrical connection members 152 are provided with a second insulating and isolating member 1425, so as to improve insulation performance between the two second electrical connection members 152 and improve use reliability of the BDU. The second insulating and isolating member 1425 and the mounting base 142 are of an integral injection molding structure. A part of the second electrical connection member 152 is located in the accommodating hole 1431 and is in direct contact with the insulating and thermally conductive member 160 embedded in the second shell cover 143, to improve heat radiation performance. It should be noted that the contacts of the main positive relay 102 and the main negative relay 105 usually control on/off of a high-voltage circuit. A large amount of heat is generated from the second electrical connection member 152. The second electrical connection member 152 is in direct contact with the insulating and thermally conductive member 160, so that heat radiation efficiency of the BDU can be effectively improved. The second electrical connection member 152 is made of an electrically conductive material, for example, an electrically conductive metal material such as copper or aluminum. The second electrical connection member 152 may be, but is not limited to, a copper bar.

In this embodiment, the main positive relay 102 is covered with a first insulating covering member 171, the first insulating covering member 171 seals the opening of the corresponding second accommodating cavity 1422, the two terminals led out from the contact of the main positive relay 102 are electrically connected to the second electrical connection member 152 through the first insulating covering member 171, a lateral portion of the first insulating covering member 171 facing away from the second accommodating cavity 1422 is provided with a first insulating portion 1711, and the first insulating portion 1711 is located between the two terminals led out from the contact of the main positive relay 102, which can improve insulation performance of the two terminals led out from the contact of the main positive relay 102, thereby facilitating improving use reliability of the main positive relay 102. In addition, reliability of insulation between the two terminals that lead out from the contact of the main positive relay 102 by using the first insulating portion 1711 is good. In this way, the spacing between the two terminals that lead out from the contact of the main positive relay 102 can be set to be small, thereby facilitating reduction of the size of the main positive relay 102, and further facilitating reduction of the size of the entire power distribution apparatus 100.

In this embodiment, the main negative relay 105 is covered with a second insulating covering member 172, the second insulating covering member 172 seals the opening of the corresponding third accommodating cavity 1423, the two terminals led out from the contact of the main negative relay 105 are electrically connected to the second electrical connection member 152 through the second insulating covering member 172, a lateral portion of the second insulating covering member 172 facing away from the third accommodating cavity 1423 is provided with a second insulating portion 1721, and the second insulating portion 1721 is located between the two terminals led out from the contact of the main negative relay 105, which can improve insulation performance of the two terminals led out from the contact of the main negative relay 105, thereby facilitating improving use reliability of the main negative relay 105. In addition, reliability of insulation between the two terminals that lead out from the contact of the main negative relay 105 by using the second insulating portion 1721 is good. In this way, the spacing between the two terminals that lead out from the contact of the main negative relay 105 can be set to be small, thereby facilitating reduction of the size of the main negative relay 105, and further facilitating reduction of the size of the entire power distribution apparatus 100.

In this embodiment, the first electrically conductive member 112 is led out from the pre-charge relay 101, the first connection terminal 111 includes a body 1111 and an elastic member 1112, the body 1111 is constructed with a plugging hole 11111, the elastic member 1112 is located in the plugging hole 11111, the second end is inserted into the plugging hole 11111, and the second end elastically butts against the elastic member 1112, to elastically clamp the second end in the plugging hole 11111. In addition, the first electrically conductive member 112 is inserted into the plugging hole 11111, and elastically butts and is fixed by using the elastic member 1112. A structure of the first connection terminal 111 is the same as that of each second connection terminal 121 that is led out from the main positive relay 102, the pre-charge resistor 103, and the fuse 104 through the second electrically conductive member 122, and that of the third connection terminal 131 that is led out from the main negative relay 105 through the third electrically conductive member 132.

### Embodiment 2

A difference between this embodiment and the foregoing embodiment is as follows: With reference to FIG. 12 and FIG. 13, the power distribution apparatus 100 is a BDU, the first electrical member 110 is a main positive relay 102, and there are two second electrical members 120, one of which is a pre-charge relay 101, and the other of which is a fuse 104. The third electrical member 130 is a main negative relay 105. The fourth electrical member 180 is a main negative relay 105. The pre-charge resistor 103, the main negative relay 105, the pre-charge relay 101, the main positive relay 102, and the fuse 104 are in a linear arrangement, an arrangement direction of which may be a direction indicated by an arrow M in FIG. 13. Electrical members in the BDU are in a linear arrangement, which helps improve structural compactness and reduces an outline size of the BDU. In addition, two adjacent electrical members are disposed at an interval. That is, a first gap 1001 is formed between the main positive relay 102 and the fuse 104 and between the main positive relay 102 and the pre-charge relay 101, a third gap 1003 is formed between the pre-charge relay 101 and the main negative relay 105, and a fourth gap 1004 is formed between the pre-charge resistor 103 and the main negative relay 105.

The first connection terminal 111 may be a terminal led out from the coil of the main positive relay 102, may be a terminal led out from the contact of the main positive relay 102, or may be a high-voltage sampling terminal of the main positive relay 102. If the second electrical member 120 is the pre-charge relay 101, the second connection terminal 121 may be a connection terminal led out from the coil of the pre-charge relay 101, or may be a high-voltage sampling terminal led out from the pre-charge relay 101. When the second electrical member 120 is the fuse 104, the second connection terminal 121 may be a terminal that is led out from the fuse 104 and that is configured to control on/off of the fuse 104, may be a terminal that is led out from the fuse 104 and that is configured to electrically connect to another electrical member, or may be a sampling terminal of the fuse 104. The third connection terminal 131 may be a terminal led out from the coil of the main negative relay 105, may be a terminal led out from the contact of the main negative relay 105, or may be a high-voltage sampling terminal of the main negative relay 105. the fourth connection terminal 181 may be a terminal that is led out from the pre-charge resistor 103 and that is configured to electrically connect to another electrical member, or may be a sampling terminal of the pre-charge resistor 103.

In this embodiment, four first connection terminals 111 are led out from the main positive relay 102, four second connection terminals 121 led out from the pre-charge relay 101 are all located on the top of the pre-charge relay 101, a second connection terminal 121 led out from the fuse 104 is located on the top of the fuse 104, a second connection terminal 121 led out from the fuse 104 is located on the top of the fuse 104, and four third connection terminals 131 led out from the main negative relay 105 are located on the top of the main negative relay 105. Two fourth connection terminals 181 led out from the pre-charge resistor 103 are both located on the top of the pre-charge resistor 103, and the first connection terminals 111, the second connection terminals 121, the third connection terminals 131, and the fourth connection terminals 181 are located on a same side of all electrical members in the power distribution apparatus 100. In this way, all of the first connection terminals 111, all of the second connection terminals 121, all of the third connection terminals 131, and all of the fourth connection terminals 181 are located outside of all of the first gaps 1001, all of the third gaps 1003, and all of the fourth gaps 1004. In this way, a spacing between electrical members can be reduced to the greatest extent, thereby improving structural compactness.

In this embodiment, with reference to FIG. 12 and FIG. 13 together, the housing 140 of the BDU includes a first shell cover 141, a mounting base 142, and a second shell cover 143. The first shell cover 141 is snap-fit on one side of the mounting base 142. The second shell cover 143 is snap-fit on the other side of the mounting base 142 that is opposite to the first shell cover 141. The mounting base 142 is constructed with one first accommodating cavity 1421, two second accommodating cavities 1422, one third accommodating cavity 1423, and one seventh accommodating cavity 1426. The main positive relay 102 is located in the first accommodating cavity 1421, the pre-charge relay 101 and the fuse 104 are respectively located in the two second accommodating cavities 1422, the main negative relay 105 is located in the third accommodating cavity 1423, and the pre-charge resistor 103 is located in the seventh accommodating cavity 1426. An opening of the first accommodating cavity 1421, an opening of the second accommodating cavity 1422 in which the fuse 104 is loaded, an opening of the third accommodating cavity 1423, and an opening of the fourth accommodating cavity 1424 are all disposed toward the first shell cover 141, so that when the first shell cover 141 is mounted on the mounting base 142, the first shell cover 141 may block the opening of the first accommodating cavity 1421, the opening of the second accommodating cavity 1422 in which the fuse 104 is loaded, the opening of the third accommodating cavity 1423, and the opening of the fourth accommodating cavity 1424. The opening of the second accommodating cavity 1422 in which the pre-charge relay 101 is loaded faces the second shell cover 143, so that when the second shell cover 143 is mounted on the mounting base 142, the opening of the second accommodating cavity 1422 in which the pre-charge relay 101 is loaded. In this way, the electrical members are encapsulated in the housing 140, thereby insulating and protecting the electrical members.

In this embodiment, the first connection terminal 111 led out from the main positive relay 102, the third connection terminal 131 led out from the main negative relay 105, the second connection terminal 121 led out from the fuse 104, and the fourth connection terminal 181 led out from the pre-charge resistor 103 may each be electrically plugged into the first electrical connection member 151 of the first shell cover 141 through a corresponding opening. The second connection terminal 121 led out from the pre-charge relay 101 is electrically plugged into the first electrical connection member 151 of the first shell cover 141 after passing through a cavity wall of the second accommodating cavity 1422.

In this embodiment, the main positive relay 102 and the main negative relay 105 are relays 110a with shells removed, and a structure of the main negative relay 105 is the same as that of the main positive relay 102. For ease of description, the structure of the main positive relay 102 is used as an example for description. The main positive relay 102 includes a switching unit 114, a first electrically conductive member 112, and a first connection terminal 111. The first connection terminal 111 is electrically connected to the switching unit 114 by using the first electrically conductive member 112. The switching unit 114 is exposed in the first accommodating cavity 1421. The switching unit 114 may be a main component that is in the main positive relay 102 and that performs switching control, that is, a unit including the electromagnet, the coil, and the contact in the relay 110a. The first connection terminal 111 is electrically connected to the switching unit 114, and the switching unit 114 is electrically connected to another electrical member different from the first electrical member 110 by using the first connection terminal 111. That the switching unit 114 is exposed in the first accommodating cavity 1421 may be understood as that, the switching unit 114 is not covered with the shell, but is directly exposed in the first accommodating cavity 1421. That is, a cavity wall of the first accommodating cavity 1421 may be directly used as the shell of the main positive relay 102. That is, the mounting base 142 and the shell of the main positive relay 102 are integrated to form an integrated structure, which helps reduce manufacturing costs. The switching unit 114 of the main positive relay 102 is directly exposed in the first accommodating cavity 1421. In this way, in the power distribution apparatus 100, a space occupied by the shell of the main positive relay 102 may be saved, thereby improving structural compactness of the power distribution apparatus 100, and helping improve performance of the power distribution apparatus 100 and reduce manufacturing costs. In addition, the main positive relay 102 is generally a component with a large volume in the power distribution apparatus 100, and the shell of the main positive relay 102 is omitted, so that a large space can be saved for the power distribution apparatus 100, thereby effectively improving the structural compactness of the power distribution apparatus 100. Certainly, in another embodiment, the main positive relay 102 and the main negative relay 105 may alternatively have different structures.

In an embodiment of the present application, a battery 1100 is provided, including the power distribution apparatus 100 according to the foregoing embodiments.

In an embodiment of the present application, a power consuming device is provided, including the power distribution apparatus 100 according to the foregoing embodiments; and/or including the battery 1100 according to the foregoing embodiments.

The foregoing descriptions are merely exemplary embodiments of the present application, but are not intended to limit the present application. Any modification, equivalent replacement, or improvement and the like made within the spirit and principle of the present application fall within the protection scope of the present application.

## Claims

1. A power distribution apparatus, comprising:
a first electrical member, comprising a first connection terminal, the first connection terminal being configured to electrically connect the first electrical member to another electrical member; and
a second electrical member, a first gap being formed between the second electrical member and the first electrical member, wherein
the first connection terminal is located outside the first gap.

2. The power distribution apparatus according to claim 1, wherein the second electrical member comprises a second connection terminal configured to electrically connect the second electrical member to another electrical member, and the second connection terminal is located outside the first gap.

3. The power distribution apparatus according to claim 2, wherein at least two second electrical members are disposed, the first gap is formed between each of the second electrical members and the first electrical member, and the first connection terminal is located outside each first gap; and/or at least one second connection terminal is located outside each first gap.

4. The power distribution apparatus according to claim 3, wherein a second gap is formed between two adjacent second electrical members, and the first connection terminal is located outside each second gap; and/or the at least one second connection terminal is located outside each second gap.

5. The power distribution apparatus according to any one of claims 2 to 4, wherein the first connection terminal and the at least one second connection terminal are located on a same side of the first electrical member and the second electrical member.

6. The power distribution apparatus according to any one of claims 3 to 5, wherein the power distribution apparatus further comprises a third electrical member, the third electrical member and the first electrical member are located on different sides of the second electrical member, a third gap is formed between the second electrical member and the third electrical member, and the at least one second connection terminal is located outside the third gap.

7. The power distribution apparatus according to claim 6, wherein the third electrical member comprises a third connection terminal configured to electrically connect the third electrical member to another electrical member, and the third connection terminal is located outside the third gap.

8. The power distribution apparatus according to claim 7, wherein the third connection terminal and the at least one second connection terminal are located on a same side of the second electrical member and the third electrical member.

9. The power distribution apparatus according to any one of claims 6 to 8, wherein the first electrical member, at least one second electrical member, and at least one third electrical member are in a linear arrangement.

10. The power distribution apparatus according to any one of claims 1 to 9, wherein the first electrical member has a first lateral portion opposite to the second electrical member, and the first connection terminal is located on a lateral portion of the first electrical member adjacent to the first lateral portion.

11. The power distribution apparatus according to any one of claims 1 to 10, wherein a plurality of first connection terminals are disposed, and at least two of the first connection terminals are located on a same side of the first electrical member.

12. The power distribution apparatus according to any one of claims 1 to 11, wherein the power distribution apparatus further comprises a first electrical connection member, the first electrical connection member has a first end and a second end, the first end is configured to connect to another electrical member different from the first electrical member, and the second end is configured to electrically plug into the first connection terminal.

13. The power distribution apparatus according to claim 12, wherein the first connection terminal comprises a body and an elastic member, the body is constructed with a plugging hole, the elastic member is located in the plugging hole, the second end is inserted into the plugging hole, and the second end elastically butts against the elastic member, to elastically clamp the second end in the plugging hole.

14. The power distribution apparatus according to claim 13, wherein the second end has a sheet shape.

15. The power distribution apparatus according to claim 12 or 13, wherein the power distribution apparatus further comprises a first shell cover and a mounting base, the first shell cover is mounted on the mounting base, the first shell cover and the mounting base define a mounting space, the first electrical member and the second electrical member are located in the mounting space, the first electrical connection member is mounted on the first shell cover, and a plugging opening of the first connection terminal is disposed toward the first shell cover.

16. The power distribution apparatus according to claim 15, wherein the first electrical connection member is embedded in the first shell cover.

17. The power distribution apparatus according to claim 15 or 16, wherein the first electrical member is a relay; the relay comprises a switching unit, and the first connection terminal is electrically connected to the switching unit; and the mounting base is constructed with a first accommodating cavity, and the switching unit is exposed in the first accommodating cavity.

18. The power distribution apparatus according to any one of claims 1 to 17, wherein the first electrical member is a resistor, a fuse, or a current sensor; and/or the second electrical member is a relay, a resistor, a fuse, or a current sensor.

19. A battery, comprising the power distribution apparatus according to claims 1 to 19.

20. A power consuming device, comprising the power distribution apparatus according to claims 1 to 19; and/or comprising the battery according to claim 20.
